# EUROPEAN PATENT APPLICATION

(11) **EP 3 993 076 A1**
(43) Date of publication of application: **04.05.2022**
(21) Application number: 20834957.1
(22) Date of filing: 29.06.2020
(51) Int. Cl.: H01L 51/44

(54) **LIGHT ABSORBING LAYER AND MANUFACTURING METHOD THEREFOR, PHOTOELECTRIC CONVERSION ELEMENT, AND INTERMEDIATE BAND-TYPE SOLAR CELL**

(30) Priority: 01.07.2019 WO PCT/JP2019/026170
(71) Applicant: Kao Corporation, Chuo-ku Tokyo 103-8210 (JP)
(72) Inventor: OKONOGI,Akinori, Wakayama-shi, Wakayama 640-8580 (JP); HOSOKAWA,Hiroji, Wakayama-shi, Wakayama 640-8580 (JP); SAWADA,Takuya, Wakayama-shi, Wakayama 640-8580 (JP)
(74) Representative: Hoffmann Eitle
(86) International application number: PCT/JP2020/025538
(87) International publication number: WO 2021/002327

(57) **Abstract**

The present invention provides: a light absorption layer for forming a photoelectric conversion element and an intermediate-band solar cell which have excellent two-step light absorption quantum yield; and a photoelectric conversion element and an intermediate-band solar cell having the light absorption layer. In addition, the present invention provides a method for manufacturing a light absorption layer that includes an intermediate-band and that has few voids. This light absorption layer: is configured so that quantum dots are scattered in the matrix of a bulk semiconductor having band gap energy of 2.0 to 3.0eV; includes an intermediate-band; and has a void rate of no more than 10%.

## Description

### TECHNICAL FIELD

The present invention relates to a light absorption layer having intermediate-band and manufacturing method therefor, a photoelectric conversion element having the light absorption layer, and an intermediate-band solar cell having the photoelectric conversion element.

### BACKGROUND ART

A photoelectric conversion element that converts light energy into electric energy is used for solar cells, optical sensors, copying machines, and the like. In particular, from the viewpoint of environmental and energy problems, photoelectric conversion elements (solar cells) utilizing sunlight that is an inexhaustible clean energy attract attention.

Since a single-junction solar cell represented by a silicon solar cell has a single band gap, the single-junction solar cell cannot exceed the photoelectric conversion efficiency of the Shockley-Queisser theoretical limit (31%). As a means to exceed this theoretical limit, an intermediate-band solar cell has been proposed. By regularly arranging nano-sized semiconductors (quantum dots) in a bulk (matrix) semiconductor at high density, an "intermediate-band" due to quantum dot interaction is formed within the band gap of the bulk semiconductor. As a result, photoexcitation from the valence band of the bulk semiconductor to the "intermediate-band" and photoexcitation from the "intermediate-band" to the conduction band of the bulk semiconductor (two-step light absorption) become possible in addition to photoexcitation from the valence band to the conduction band of the bulk semiconductor, thereby to be able to use multiple solar energies. Thus, the photoelectric conversion efficiency is expected to be improved. However, since the intermediate-band solar cell is manufactured by a dry process such as a molecular beam epitaxy (MBE) method, such a solar cell is expensive and elements that can be used are limited to GaAs (band gap energy 1.4 eV) etc. Therefore, it is difficult to optimize the band structure and there is a limit in improving the photoelectric conversion efficiency.

On the other hand, a manufacturing method of a quantum dot solar cell by using a wet process has been proposed. For example, JP-A-2014-135445 has been proposed a method for manufacturing a semiconductor device having a photoelectric conversion layer having a quantum dot structure having a PN junction, wherein when forming the photoelectric conversion layer in which a first conductive semiconductor layer made of first conductive semiconductor particles and a second conductive semiconductor layer made of second conductive semiconductor particles different from the first conductive semiconductor particles are sequentially laminated on a substrate, or in which second conductive semiconductor particles different from first conductive semiconductor particles are dispersed in a first conductive semiconductor layer made of first conductive semiconductor particles on a substrate, the photoelectric conversion layer is formed by spraying one or both of the first conductive semiconductor particles and the second conductive semiconductor particles onto the substrate.

Also, a manufacturing method of an intermediate-band solar cell by using a wet process has been proposed. For example, JP-6343406 has been proposed a method for manufacturing a light absorption layer having an intermediate-band, wherein quantum dots are dispersed in a matrix of a bulk semiconductor, which method contains the following step 1, step 2, and step 3:
(step 1) a step of ligand-exchanging the organic ligand of an organic ligand-containing quantum dot to a halogen element-containing substance to obtain a quantum dot solid containing the halogen element-containing substance as a ligand,
(step 2) a step of obtaining a dispersion by mixing the quantum dot solid obtained in step 1 with a solution or mixed solution containing one or more substances selected from a bulk semiconductor and a precursor thereof,
(step 3) a step of obtaining a light absorption layer from the dispersion obtained in step 2.

### SUMMARY OF THE INVENTION

In order to improve the photoelectric conversion efficiency of an intermediate-band solar cell, it is necessary to improve the quantum efficiency of two-step light absorption. Examples of a method for improving the quantum efficiency of two-step light absorption include a method including filling a light absorption layer with quantum dots at a high density. However, in an attempt to produce a light absorption layer filled with quantum dots, crystal growth of a bulk semiconductor is inhibited in a conventional step of producing a light absorption layer. As a result, many voids are generated in the produced light absorption layer. Accordingly, there arises a problem that the quantum efficiency of two-step light absorption cannot be improved.

The present invention relates to a light absorption layer for forming a photoelectric conversion element and an intermediate-band solar cell excellent in quantum efficiency of two-step light absorption, a photoelectric conversion element having the light absorption layer, and an intermediate-band solar cell. The present invention also relates to a method for producing a light absorption layer having an intermediate-band and having few voids.

The present inventors have found that the quantum efficiency of two-step light absorption of a photoelectric conversion element is improved by using the light absorption layer having an intermediate-band and having few voids obtained by dispersing quantum dots at a high density in a matrix of a bulk semiconductor having a specific band gap energy.

That is, the present invention is related to a light absorption layer, wherein quantum dots are dispersed in a matrix of a bulk semiconductor having a band gap energy of 2.0 eV or more and 3.0 eV or less, and the light absorption layer has an intermediate-band and has a porosity of 10% or less.

In addition, the present inventors have found a method for producing a light absorption layer having an intermediate-band and having few voids by controlling the generation of crystal nuclei of a bulk semiconductor and the rate of crystal growth of the bulk semiconductor.

That is, the present invention is related to a method for manufacturing a light absorption layer having an intermediate-band and having a porosity of 10% or less, wherein quantum dots are dispersed in a matrix of a bulk semiconductor, which method comprises the following step 1, step 2, and step 3:
(step 1) a step of ligand-exchanging the organic ligand of an organic ligand-containing quantum dot to a halogen element-containing substance to obtain a quantum dot solid containing the halogen element-containing substance as a ligand,
(step 2) a step of obtaining a dispersion by mixing the quantum dot solid obtained in step 1 with a solution or mixed solution containing one or more substances selected from a bulk semiconductor and a precursor thereof,
(step 3) a step of obtaining a light absorption layer from the dispersion obtained in step 2.

By using a bulk semiconductor (for example, CH₃NH₃PbBr₃) having a band gap energy of 2.0 eV or more and 3.0 eV or less and quantum dots (for example, PbS quantum dots) as a material for forming a light absorption layer, in addition to light in a short wavelength region that can be absorbed by a bulk semiconductor, light in a wide wavelength region including a long wavelength region such as near infrared that can be absorbed by quantum dots can be absorbed, so that a photoelectric conversion element having a photoelectric conversion function in a wide wavelength region can be obtained. Moreover, since quantum dots are dispersed in the matrix of a bulk semiconductor at a high density, an intermediate-band is formed in the band gap of the bulk semiconductor due to the interaction between the quantum dots. Accordingly, for example, two-stage light absorption of light excitation from the valence band of the bulk semiconductor to the intermediate-band and light excitation from the intermediate-band to the conduction band of the bulk semiconductor is provided, so that the photoelectric conversion efficiency is improved.

In addition, the light absorption layer of the present invention has few voids, whereas quantum dots are dispersed in the matrix of a bulk semiconductor at a high density. When there are few voids in the light absorption layer, it is considered that quantum dots in the light absorption layer are likely to be regularly arranged, so that an intermediate-band is likely to be formed.

Therefore, by using the light absorption layer of the present invention, it is possible to produce a photoelectric conversion element and an intermediate-band solar cell excellent in quantum efficiency of two-step light absorption.

### BRIEF DESCRIPTION OF THE DRAWINGS

Fig. 1 is a schematic cross-sectional view showing an example of the structure of a photoelectric conversion element of the present invention.
Fig. 2 is a cross-sectional SEM image of a light absorption layer prepared in Example 1.
Fig. 3 is a cross-sectional SEM image of a light absorption layer prepared in Example 2.
Fig. 4 is a cross-sectional SEM image of a light absorption layer prepared in Comparative Example 1.
Fig. 5 is a schematic view showing a solid in which quantum dots and perovskite are complexed and voids in the solid in the light absorption layer prepared in Example 1.
Fig. 6 is a schematic view showing a solid in which quantum dots and perovskite are complexed and voids in the solid in the light absorption layer prepared in Example 2.
Fig. 7 is a schematic view showing a solid in which quantum dots and perovskite are complexed and voids in the solid in the light absorption layer prepared in Comparative Example 1.

### MODE FOR CARRYING OUT THE INVENTION

### <Light absorption layer>

The light absorption layer of the present invention contains, as light absorbers, a bulk semiconductor having a band gap energy of 2.0 eV or more and 3.0 eV or less and quantum dots dispersed in a matrix of the bulk semiconductor. The light absorption layer of the present invention may contain other light absorbers other than those mentioned above as long as the effect of the present invention is not impaired.

The light absorption layer of the present invention has an intermediate-band. The intermediate-band is an energy level formed within the band gap of the bulk semiconductor by the interaction between quantum dots and exists at the energy position near the lower end of the conduction band of the quantum dot and/or near the upper end of the valence band of the quantum dot. The intermediate-band is formed, for example, by regularly arranging quantum dots at high density in a bulk semiconductor matrix. If an intermediate-band is present within the band gap of the bulk semiconductor, for example, two-step light absorption occurs in such a manner that electrons photoexcited from a valence band of the bulk semiconductor to an intermediate-band further photoexcite from the intermediate-band to a conduction band of the bulk semiconductor. Therefore, the presence of the intermediate-band can be confirmed by measuring the quantum efficiency of two-step light absorption, that is, the external quantum efficiency difference described in Example.

In the present invention, the external quantum efficiency difference (ΔEQE) of the light absorption layer at 820 nm is inferred as corresponding to the quantum efficiency of two-step light absorption in such a manner that electrons photoexcited from the valence band of the bulk semiconductor to the intermediate-band further photoexcite to the conduction band of the bulk semiconductor. The external quantum efficiency difference (ΔEQE) of the light absorption layer at 820 nm is preferably 0.0005% or more, more preferably 0.005% or more, still more preferably 0.05% or more, from the viewpoint of improving the photoelectric conversion efficiency.

In the present invention, the external quantum efficiency difference (ΔEQE) of the light absorption layer at 1240 nm is inferred as corresponding to the quantum efficiency of two-step light absorption in such a manner that electrons photoexcited from the valence band of the quantum dot to the intermediate-band further photoexcite to the conduction band of the bulk semiconductor. The external quantum efficiency difference of the light absorption layer at 1240 nm is preferably 0.0002% or more, more preferably 0.002% or more, still more preferably 0.02% or more, from the viewpoint of improving the photoelectric conversion efficiency.

From the viewpoint of improving the photoelectric conversion efficiency, the energy difference between the valence band of the bulk semiconductor and the intermediate-band is preferably 1.1 eV or more, more preferably 1.2 eV or more, still more preferably 1.3 eV or more, still more preferably 1.4 eV or more, and preferably 2.0 eV or less, more preferably 1.8 eV or less, still more preferably 1.6 eV or less.

Also, from the viewpoint of improving the photoelectric conversion efficiency, the energy difference between the intermediate-band and the conduction band of the bulk semiconductor is preferably 0.5 eV or more, more preferably 0.6 eV or more, still more preferably 0.7 eV or more, and preferably 2.0 eV or less, more preferably 1.5 eV or less, still more preferably 1.0 eV or less, still more preferably 0.9 eV or less.

The bulk semiconductor is not particularly limited as long as it has a band gap energy of 2.0 eV or more and 3.0 eV or less from the viewpoint of obtaining sufficient photoelectric conversion efficiency (voltage), and may be an organic material, an inorganic material, or an organic-inorganic composite compound. However, from the viewpoints of photoelectric conversion efficiency, durability, cost, and ease of production, the bulk semiconductor is preferably an inorganic material or an organic-inorganic composite compound, more preferably an organic-inorganic composite compound. From the same point of view, the bulk semiconductor is preferably a perovskite compound, more preferably an organic-inorganic composite perovskite compound. These bulk semiconductors may be used singly or in combination of two or more kinds thereof having different band gap energies.

From the viewpoint of improving the photoelectric conversion efficiency (voltage), the band gap energy of the bulk semiconductor is preferably 2.1 eV or more, more preferably 2.2 eV or more, and from the viewpoint of improving the photoelectric conversion efficiency (current), the band gap energy of the bulk semiconductor is preferably 2.9 eV or less, more preferably 2.8 eV or less, still more preferably 2.6 eV or less, still more preferably 2.4 eV or less. The band gap energies of the bulk semiconductor and the quantum dot can be determined from the absorption spectrum measured at 25°C by the method described in Examples described later. The wavelength corresponding to the band gap energy determined from the absorption spectrum is called an absorption edge wavelength.

The perovskite compound is a compound having a perovskite type crystal structure, and from the viewpoint of improving durability (moisture resistance) and photoelectric conversion efficiency, a perovskite compound having a band gap energy of 2.0 eV or more and 3.0 eV or less is used. The perovskite compound may be used singly or in combination of two or more kinds having different band gap energies.

A preferable embodiment of the band gap energy of the perovskite compound is similar to that of the band gap energy of the bulk semiconductor.

The perovskite compound is not limited as long as it has the band gap energy and known ones can be used without any particular limitation, but it is preferable to use one or more kinds selected from a compound represented by the following general formula (1) and a compound represented by the following general formula (2). From the viewpoint of achieving both durability and photoelectric conversion efficiency, a compound represented by the following general formula (1) is more preferable.

RMX₃ (1)

(R is a monovalent cation, M is a divalent metal cation, and X is a halogen anion.)

R¹R²R³ₙ₋₁MₙX₃ₙ₊₁ (2)

(R¹, R² and R³ are each independently a monovalent cation, M is a divalent metal cation, X is a halogen anion, and n is an integer of 1 to 10.)

The R is a monovalent cation, for example, a cation of the group 1 of the periodic table and includes an organic cation. Examples of the cation of the group 1 of the periodic table include Li⁺, Na⁺, K⁺, and Cs⁺. Examples of the organic cation include an ammonium ion which may have a substituent and a phosphonium ion which may have a substituent. There is no particular limitation on the substituent. Examples of the optionally substituted ammonium ion include an alkylammonium ion, a formamidinium ion and an arylammonium ion, and from the viewpoint of achieving both durability and photoelectric conversion efficiency, the optionally substituted ammonium ion is preferably one or more kinds selected from an alkyl ammonium ion and a formamidinium ion, more preferably one or more kinds selected from a monoalkylammonium ion and a formamidinium ion, still more preferably one or more kinds selected from a methylammonium ion, an ethylammonium ion, a butylammonium ion and a formamidinium ion, and even still more preferably a methylammonium ion.

Each of R¹, R², and R³ mentioned above is independently a monovalent cation, and any or all of R¹, R², and R³ may be the same. For example, examples of the monovalent cation include a cation of the group 1 of the periodic table and an organic cation. Examples of the cation of the group 1 of the periodic table include Li⁺, Na⁺, K⁺, and Cs⁺. Examples of the organic cation include an ammonium ion which may have a substituent and a phosphonium ion which may have a substituent. There is no particular restriction on the substituent. Examples of the optionally substituted ammonium ion include an alkylammonium ion, a formamidinium ion and an arylammonium ion, and from the viewpoint of achieving both durability and photoelectric conversion efficiency, the optionally substituted ammonium ion is preferably one or more kinds selected from an alkyl ammonium ion and a formamidinium ion, more preferably a monoalkylammonium ion, still more preferably one or more kinds selected from a methylammonium ion, an ethylammonium ion, a butylammonium ion, a hexylammonium ion, an octylammonium ion, a decylammonium ion, a dodecyl ammonium ion, a tetradecyl ammonium ion, a hexadecyl ammonium ion, and an octadecyl ammonium ion.

The n is an integer of 1 to 10 and from the viewpoint of achieving both durability and photoelectric conversion efficiency, n is preferably 1 to 4.

The M is a divalent metal cation and includes, for example, Pb²⁺, Sn²⁺, Hg²⁺, Cd²⁺, Zn²⁺, Mn²⁺, Cu²⁺, Ni²⁺, Fe²⁺, Co²⁺, Pd²⁺, Ge²⁺, Y²⁺, and Eu²⁺. From the viewpoint of excellent durability (moisture resistance) and photoelectric conversion efficiency, the M is preferably Pb²⁺, Sn²⁺, or Ge²⁺, more preferably Pb²⁺ or Sn²⁺, still more preferably Pb²⁺.

The X is a halogen anion, and examples thereof include a fluorine anion, a chlorine anion, a bromine anion, and an iodine anion. In order to obtain a perovskite compound having a desired band gap energy, the X is preferably a fluorine anion, a chlorine anion or a bromine anion, more preferably a chlorine anion or a bromine anion, still more preferably a bromine anion.

Examples of the compound represented by the general formula (1) having a band gap energy of 2.0 eV or more and 3.0 eV or less include CH₃NH₃PbCl₃, CH₃NH₃PbBr₃, CH₃NH₃PbBr₂I, CH₃NH₃SnCl₃, CH₃NH₃SnBr₃, CH(=NH)NH₃PbCl₃, and CH(=NH)NH₃PbBr₃. Among these, from the viewpoint of achieving both durability and photoelectric conversion efficiency at the same time, CH₃NH₃PbBr₃ and CH(=NH)NH₃PbBr₃ are preferable and CH₃NH₃PbBr₃ is more preferable.

Examples of the compound represented by the general formula (2) having a band gap energy of 2.0 eV or more and 3.0 eV or less include (C₄H₉NH₃)₂PbI₄, (C₆H₁₃NH₃)₂PbI₄, (C₈H₁₇NH₃)₂PbI₄, (C₁₀H₂₁NH₃)₂PbI₄, (C₁₂H₂₅NH₃)₂PbI₄, (C₄H₉NH₃)₂(CH₃NH₃) Pb₂I₇, (C₆H₁₃NH₃)₂(CH₃NH₃)Pb₂I₇, (C₈H₁₇NH₃)₂(CH₃NH₃)Pb₂I₇, (C₁₀H₂₁NH₃)₂(CH₃NH₃)Pb₂I₇, (C₁₂H₂₅NH₃)₂(CH₃NH₃)Pb₂I₇, (C₄H₉NH₃) ₂(CH₃NH₃)₂Pb₃I₁₀, (C₆H₁₃NH₃)₂(CH₃NH₃)₂Pb₃I₁₀, (C₈H₁₇NH₃)₂(CH₃NH₃)₂Pb₃I₁₀, (C₁₀H₂₁NH₃)₂(CH₃NH₃)₂Pb₃I₁₀, (C₁₂H₂₅NH₃)₂(CH₃NH₃)₂Pb₃I₁₀, (C₄H₉NH₃) ₂PbBr₄, (C₆H₁₃NH₃)₂PbBr₄, (C₈H₁₇NH₃)₂PbBr₄, (C₁₀H₂₁NH₃)₂PbBr₄, (C₄H₉NH₃) ₂(CH₃NH₃)Pb₂Br₇, (C₆H₁₃NH₃)₂(CH₃NH₃)Pb₂Br₇, (C₈H₁₇NH₃)₂(CH₃NH₃)Pb₂Br₇, (C₁₀H₂₁NH₃)₂(CH₃NH₃)Pb₂Br₇, (C₁₂H₂₅NH₃)₂(CH₃NH₃)Pb₂Br₇, (C₄H₉NH₃) ₂(CH₃NH₃)₂Pb₃Br₁₀, (C₆H₁₃NH₃)₂(CH₃NH₃)₂Pb₃Br₁₀, (C₈H₁₇NH₃)₂(CH₃NH₃)₂Pb₃Br₁₀, (C₁₀H₂₁NH₃)₂(CH₃NH₃)₂Pb₃Br₁₀, (C₁₂H₂₅NH₃)₂(CH₃NH₃)₂Pb₃Br₁₀, (C₄H₉NH₃) ₂(CH₃NH₃)₂Pb₃Cl₁₀, (C₆H₁₃NH₃)₂(CH₃NH₃)₂Pb₃Cl₁₀, (C₈H₁₇NH₃)₂(CH₃NH₃)₂Pb₃Cl₁₀, (C₁₀H₂₁NH₃)₂(CH₃NH₃)₂Pb₃Cl₁₀, and (C₁₂H₂₅NH₃)₂(CH₃NH₃)₂Pb₃Cl₁₀.

The crystallite diameter of the perovskite compound of the light absorption layer is preferably 10 nm or more, more preferably 20 nm or more, still more preferably 30 nm or more, still more preferably 40 nm or more, from the viewpoint of improving the photoelectric conversion efficiency by improving a movement speed of a carrier and is preferably 1000 nm or less from the same viewpoint. The crystallite diameter of the light absorption layer in the range of 100 nm or less can be measured by the method described in Examples below. Further, the crystallite diameter in the range exceeding 100 nm cannot be measured by the method described in Examples described later but does not exceed the thickness of the light absorption layer.

The perovskite compound can be produced, for example, from a perovskite compound precursor as described later. As a precursor of the perovskite compound, for example, in the case where the perovskite compound is a compound represented by the general formula (1), a combination of a compound represented by MX₂ and a compound represented by RX can be mentioned. Also, in the case where the perovskite compound is a compound represented by the general formula (2), a combination of a compound represented by MX₂ with one or more kinds selected from a compound represented by R¹X, a compound represented by R²X, and a compound represented by R³X can be mentioned.

The perovskite compound in the light absorption layer can be identified by the conventional methods such as element analysis, infrared (IR) spectrum, Raman spectrum, nuclear magnetic resonance (NMR) spectrum, X-ray diffraction pattern, absorption spectrum, emission spectrum, electron microscope observation, and electron beam diffraction.

The quantum dot is inorganic nanoparticle having a crystal structure with a particle diameter of about 20 nm or less and exhibit physical properties different from those of the bulk semiconductor due to the expression of the quantum size effect. Although known quantum dots can be used without particular limitation, it is preferred to use a quantum dot having a band gap energy of 0.2 eV or more and less than the band gap energy of the bulk semiconductor from the viewpoint of complementing the band gap energy which the bulk semiconductor does not have and improving the photoelectric conversion efficiency in the near infrared light region. The quantum dots may be used singly or in combination of two or more kinds having different band gap energies. When two or more kinds of bulk semiconductors having different band gap energies are used, "the band gap energy less than the band gap energy of the bulk semiconductor", which is the upper limit of the band gap energy of the quantum dot, means a band gap energy less than the maximum value of the band gap energy of two or more kinds of bulk semiconductors. Hereinafter, unless otherwise specified, preferred embodiments of quantum dots are preferred embodiments common to the light absorption layer and its raw materials.

From the viewpoint of improving the photoelectric conversion efficiency (voltage), the band gap energy of the quantum dot is preferably 0.6 eV or more, more preferably 0.7 eV or more, still more preferably 0.8 eV or more, and from the viewpoint of improving the photoelectric conversion efficiency (current), the band gap energy of the quantum dot is preferably 1.6 eV or less, more preferably 1.5 eV or less, still more preferably 1.4 eV or less, still more preferably 1.3 eV or less.

Regarding the quantum dots, if the particle size and kind of quantum dots are determined by electron microscopic observation, electron beam diffraction, X-ray diffraction pattern, etc., it is also possible to calculate the band gap energy from the correlation between the particle size and the band gap energy (see, for example, ACS Nano 2014, 8, 6363-6371).

The difference between the band gap energy of the bulk semiconductor and the band gap energy of the quantum dot is preferably 0.4 eV or more, more preferably 0.8 eV or more, still more preferably 1.0 eV or more, even still more preferably 1.2 eV or more, and preferably 2.8 eV or less, more preferably 2.0 eV or less, still more preferably 1.6 eV or less, even still more preferably 1.4 eV or less, from the viewpoint of improving photoelectric conversion efficiency.

The particle diameter of the quantum dot is not particularly limited as long as it is a particle diameter that exhibits a quantum effect, but from the viewpoints of improving dispersibility, structural stability, and photoelectric conversion efficiency, the particle diameter is preferably 1 nm or more, more preferably 2 nm or more, still more preferably 3 nm or more, and preferably 20 nm or less, more preferably 10 nm or less, still more preferably 5 nm or less. The particle size of the quantum dot can be measured by a conventional method such as crystallite diameter analysis of XRD (X-ray diffraction) or transmission electron microscope observation.

Examples of the quantum dots having such a band gap energy include metal oxides, metal chalcogenides (such as sulfides, selenides, and tellurides), specifically PbS, PbSe, PbTe, CdS, CdSe, CdTe, Sb₂S₃, Bi₂S₃, Ag₂S, Ag₂Se, Ag₂Te, Au₂S, Au₂Se, Au₂Te, Cu₂S, Cu₂Se, Cu₂Te, Fe₂S, Fe₂Se, Fe₂Te, In₂S₃, SnS, SnSe, SnTe, CuInS₂, CuInSe₂, CuInTe₂, EuS, EuSe, and EuTe. From the viewpoint of excellent durability (oxidation resistance) and photoelectric conversion efficiency, the quantum dot preferably contains Pb element, more preferably PbS or PbSe, still more preferably PbS.

From the viewpoints of dispersibility in the light absorption layer and the dispersion, ease of production, cost, and expression of excellent performance, the quantum dot mentioned above may include preferably a quantum dot containing a halogen element-containing substance as a ligand, or a quantum dot containing an organic compound and a halogen element-containing substance as ligands.

Examples of the organic compound as a ligand (hereinafter also referred to as an organic ligand) include a carboxy group-containing compound, an amino group-containing compound, a thiol group-containing compound, and a phosphino group-containing compound.

Examples of the carboxyl group-containing compound include oleic acid, stearic acid, palmitic acid, myristic acid, lauric acid, capric acid, and the like.

Examples of the amino group-containing compound include oleylamine, stearylamine, palmitylamine, myristylamine, laurylamine, caprylamine, octylamine, hexylamine, butylamine and the like.

Examples of the thiol group-containing compound include ethanethiol, ethanedithiol, benzenethiol, benzenedithiol, decanethiol, decanedithiol, mercaptopropionic acid, and the like.

Examples of the phosphino group-containing compound include trioctylphosphine, tributylphosphine, and the like.

The organic ligand is preferably a carboxy group-containing compound or an amino group-containing compound, more preferably a carboxy group-containing compound, still more preferably carboxylic acid, still more preferably fatty acid, still more preferably fatty acid having 8 to 30 carbon atoms, still more preferably fatty acid having 12 to 18 carbon atoms, still more preferably unsaturated fatty acid having 12 to 18 carbon atoms, still more preferably oleic acid, from the viewpoints of ease of production, dispersion stability, versatility, cost, and excellent performance expression of the quantum dot.

The halogen element of the halogen element-containing substance as the ligand is not particularly limited, and examples thereof include fluorine, chlorine, bromine, and iodine. The halogen element is preferably iodine or bromine, more preferably iodine, from the viewpoints of ease of production, dispersion stability, versatility, cost, expression of excellent performance of quantum dots, and the like.

Examples of the halogen element-containing substance as the ligand include iodine, ammonium iodide, and methylammonium iodide, and iodine is preferable from the viewpoints of ease of production, dispersion stability, versatility, cost, expression of excellent performance of quantum dots, and the like.

The quantum dots of the light absorption layer can be identified, for example, by element analysis, infrared (IR) spectrum, Raman spectrum, nuclear magnetic resonance (NMR) spectrum, X-ray diffraction pattern, absorption spectrum, emission spectrum, small angle X-ray scattering, electron microscopic observation, electron beam diffraction, and the like.

A preferable combination of the perovskite compound and the quantum dot is preferably a combination of compounds containing the same metal element from the viewpoint of the uniform dispersibility of quantum dots, durability, and photoelectric conversion efficiency, for example, a combination of CH₃NH₃PbBr₃ and PbS, a combination of CH₃NH₃PbBr₃ and PbSe, a combination of CH(=NH)NH₃PbBr₃ and PbS, and a combination of CH(=NH)NH₃PbBr₃ and PbSe, and more preferably a combination of CH₃NH₃PbBr₃ and PbS.

The content of the quantum dots in the light absorption layer is preferably 7.5% by mass or more, more preferably 10% by mass or more, still more preferably 15% by mass or more, further preferably 20% by mass or more from the viewpoint of filling the quantum dots at a high density to reduce the distance between the quantum dots to cause the quantum dots to interact with each other, thereby forming an intermediate-band in the light absorption layer, so that the quantum efficiency of two-step light absorption is improved, and is preferably 40% by mass or less, more preferably 30% by mass or less, still more preferably 25% by mass or less from the viewpoint of improving the film formability and photoelectric conversion efficiency by suppressing carrier movement from the bulk semiconductor to the quantum dots.

From the viewpoint of improving the quantum efficiency of two-stage absorption, the light absorption layer of the present invention has a porosity of 10% or less, preferably 8% or less, more preferably 7% or less, still more preferably 6% or less. In the present invention, the porosity refers to the ratio of voids in a solid in which the bulk semiconductor and the quantum dots are complexed. The porosity is measured by the method described in Examples in detail. When the porosity of the light absorption layer is 10% or less, it is considered that the distance between the quantum dots becomes a distance necessary for forming the intermediate-band, so that the interaction between the quantum dots increases. Therefore, it is considered that the quantum efficiency of two-stage absorption is remarkably improved.

The thickness of the light absorption layer is not particularly limited, but is preferably 30 nm or more, more preferably 50 nm or more, still more preferably 80 nm or more, from the viewpoint of increasing light absorption to improve photoelectric conversion efficiency, and preferably 1000 nm or less, more preferably 800 nm or less, still more preferably 600 nm or less, even still more preferably 500 nm or less, from the viewpoint of improving photoelectric conversion efficiency by improving carrier transfer efficiency to a hole transport material layer and an electron transport material layer. The thickness of the light absorption layer can be measured by a measuring method such as electron microscope observation of the cross section of the film.

From the viewpoint of improving the strength of a hole transport material (HTM) layer, the surface smoothness of the light absorption layer is preferably 100 nm or more, more preferably 200 nm or more, still more preferably 300 nm or more, even still more preferably 400 nm or more, and from the viewpoint of improving the photoelectric conversion efficiency, the surface smoothness of the light absorption layer is preferably 1000 nm or less, more preferably 800 nm or less, still more preferably 700 nm or less.

### <Method for manufacturing light absorption layer>

The method for manufacturing the light absorption layer is not particularly limited. For example, a so-called wet process in which a dispersion containing the bulk semiconductor (for example, perovskite compound) and/or a precursor thereof and the quantum dot is coated on a substrate and then dried is preferably mentioned. From the viewpoints of ease of production, cost, storage stability of the dispersion, improvement of photoelectric conversion efficiency, etc., a manufacturing method including the following step 1, step 2, and step 3 is preferable.
(step 1) a step of ligand-exchanging the organic ligand of an organic ligand-containing quantum dot to a halogen element-containing substance to obtain a quantum dot solid containing the halogen element-containing substance as a ligand,
(step 2) a step of obtaining a dispersion by mixing the quantum dot solid obtained in step 1 with a solution or mixed solution containing one or more substances selected from a bulk semiconductor and a precursor thereof,
(step 3) a step of obtaining a light absorption layer from the dispersion obtained in step 2.

The step (step 1) of ligand-exchanging the organic ligand of an organic ligand-containing quantum dot to a halogen element-containing substance to obtain a quantum dot solid containing the halogen element-containing substance as a ligand is preferable from the viewpoints of improving the dispersibility of the dispersion containing the bulk semiconductor and/or its precursor and the quantum dots and improving the photoelectric conversion efficiency by improving the carrier transfer speed in the light absorption layer.

In general, there is a case where quantum dots are synthesized by using, as a ligand, a hydrophobic organic compound having a relatively large molecular size, such as oleic acid, for controlling the particle diameter of the quantum dots, inhibiting aggregation, improving the dispersibility, and the like. In this case, the quantum dots exhibit excellent dispersibility in a non (or low)-polar organic solvent such as toluene, but the dispersibility in a polar organic solvent such as N,N-dimethylformamide and methanol is poor. Accordingly, when the solvent for dispersing or dissolving the bulk semiconductor and/or its precursor is a polar organic solvent, it is necessary to disperse the quantum dots in the polar organic solvent, and it is preferable to coordinate a substance having high compatibility with the polar organic solvent to the quantum dot. In addition, organic compounds which are relatively large in molecular size and are hydrophobic, such as oleic acid, are low in conductivity and hinder diffusion of carriers in the light absorption layer. Therefore, from the viewpoint of improving the carrier transfer speed in the light absorption layer to improve the photoelectric conversion efficiency, it is preferable to coordinate a substance having a relatively small molecular size to a quantum dot. From the above viewpoint, the ligand of the quantum dot includes preferably one or more halogen element-containing substances selected from iodine, ammonium iodide, methylammonium iodide, bromine, ammonium bromide and methylammonium bromide and the like, more preferably iodine or bromine, still more preferably iodine.

As a method for ligand exchange of an organic ligand of the quantum dot containing the organic ligand to a halogen element-containing substance, there is mentioned preferably a method of exchanging a ligand in a dispersion and more preferably a method in which a dispersion of the quantum dot containing the organic ligand and a raw material solution of a halogen element-containing substance are mixed over time at room temperature (25°C) without stirring and allowed to stand to perform ligand exchange, from the viewpoints of ease of production, cost, storage stability of the dispersion, and improvement of photoelectric conversion efficiency.

As the halogen element-containing substance raw material used for the ligand exchange, it includes preferably methylammonium iodide (methylamine hydroiodide), ammonium iodide, iodine, methylammonium bromide (methylamine hydrobromide), ammonium bromide, bromine and the like. However, from the viewpoints of ease of production, cost, storage stability of the dispersion, and improvement of photoelectric conversion efficiency, one or more members selected from methylammonium iodide (methylamine hydroiodide), ammonium iodide, methylammonium bromide (methylamine hydrobromide), and ammonium bromide are preferred; one or more members selected from methylammonium iodide (methylamine hydroiodide) and methylammonium bromide (methylamine hydrobromide) are more preferred; and methylammonium iodide (methylamine hydroiodide) is still more preferred.

From the viewpoints of ease of production, cost, storage stability of the dispersion, improvement of photoelectric conversion efficiency and the like, the mixing amount of the halogen element-containing substance raw material used for ligand exchange is preferably such that the molar ratio of the halogen element to the organic compound on the quantum dot surface is preferably 0.1 or more, more preferably 1 or more, still more preferably 1.5 or more, and preferably 10 or less, more preferably 8 or less, still more preferably 5 or less, still more preferably 3 or less.

From the viewpoints of ease of production, storage stability of the dispersion, improvement of photoelectric conversion efficiency and the like, the solvent used for ligand exchange is preferably a mixed solvent of a solvent capable of dispersing quantum dots well and a solvent capable of dissolving a halogen element-containing substance raw material. The solvent for dispersing the quantum dots is preferably one or more non-(low)polar organic solvents selected from toluene, hexane, octane and the like, and is more preferably toluene. The solvent for dissolving the halogen element-containing substance raw material is preferably at least one aprotic polar organic solvent selected from N,N-dimethylformamide, dimethyl sulfoxide, γ-butyrolactone and the like, more preferably N,N-dimethylformamide.

The solid content concentration of the quantum dot in the quantum dot dispersion to be mixed at the time of ligand exchange is preferably 10 mg/mL or more, more preferably 50 mg/mL or more, still more preferably 80 mg/mL or more, and preferably 1000 mg/mL or less, more preferably 500 mg/mL or less, still more preferably 200 mg/mL or less, still more preferably 120 mg/mL or less, from the viewpoints of ease of production, cost, storage stability of the dispersion, improvement of photoelectric conversion efficiency and the like.

The concentration of the halogen element-containing substance raw material in the halogen element-containing substance raw material solution to be mixed at the time of ligand exchange is preferably 0.01 mol/L or more, more preferably 0.1 mol/L or more, still more preferably 0.2 mol/L or more, and preferably 1 mol/L or less, more preferably 0.5 mol/L or less, still more preferably 0.3 mol/L or less, from the viewpoints of ease of production, cost, storage stability of the dispersion, improvement of photoelectric conversion efficiency and the like.

The method of mixing the quantum dot dispersion and the halogen element-containing substance raw material solution at the time of ligand exchange is not particularly limited as long as it is a method of mixing without stirring over a long period of time. However, from the viewpoints of ease of production, cost, storage stability of the dispersion, improvement of photoelectric conversion efficiency and the like, preferred is a continuous method or a dropping method (semi-continuous method) and more preferred is a dropping method.

As the continuous method, a method of mixing a raw material solution of a halogen element-containing substance in a quantum dot dispersion or a method of mixing a quantum dot dispersion in a raw material solution of a halogen element-containing substance may be used. However, from the viewpoints of ease of production, cost, storage stability of the dispersion, improvement of photoelectric conversion efficiency and the like, a method of mixing a raw material solution of a halogen element-containing substance in a quantum dot dispersion is preferable. The mixing speed is preferably 25 µl/sec or less, more preferably 5 µl/sec or less, still more preferably 3 µl/sec or less, and preferably 0.2 µl/sec or more, more preferably 0.4 µl/sec or more, still more preferably 1.5 µl/sec or more, from the viewpoint of ease of production, cost, storage stability of the dispersion, improvement of photoelectric conversion efficiency and the like.

As the dropping method, a method of dropping a raw material solution of a halogen element-containing substance to a quantum dot dispersion or a method of dropping a quantum dot dispersion to a raw material solution of a halogen element-containing substance may be used. However, from the viewpoints of ease of production, cost, storage stability of the dispersion, improvement of photoelectric conversion efficiency and the like, a method of dropping a raw material solution of a halogen element-containing substance to a quantum dot dispersion is preferable. The dropping rate is preferably 1 drop/1 second or less, more preferably 1 drop/5 seconds or less, still more preferably 1 drop/8 seconds or less, and preferably 1 drop/100 seconds or more, more preferably 1 drop/50 seconds or more, still more preferably 1 drop/15 seconds or more, from the viewpoints of ease of production, cost, storage stability of the dispersion, improvement of photoelectric conversion efficiency and the like.

From the viewpoints of ease of production, cost, storage stability of the dispersion, improvement of photoelectric conversion efficiency and the like, the time allowed to stand still the mixture after mixing the quantum dot dispersion and the halogen element-containing substance raw material solution is preferably 0.1 hours or more, more preferably 1 hour or more, still more preferably 10 hours or more, and preferably 100 hours or less, more preferably 48 hours or less, still more preferably 24 hours or less.

As a method for obtaining a quantum dot solid having an organic compound and a halogen element-containing substance as the ligands after ligand exchange, there is a preferable method comprising adding a washing solvent to a mixture dispersion of a quantum dot dispersion and a halogen element-containing substance raw material solution and filtering the resulting mixture to remove the organic compound coordinated on the surface of the quantum dot, the excess halogen element-containing substance raw material and the solvent. The washing solvent is preferably an organic solvent in which any quantum dots before and after ligand exchange are hardly dispersed and an organic compound and a halogen element-containing substance are soluble, and from the viewpoints of ease of production, cost, storage stability of the dispersion, improvement of photoelectric conversion efficiency and the like, an alcohol solvent is more preferable, and methanol is still more preferable. The amount of the washing solvent is preferably 0.1 or more, more preferably 0.5 or more, still more preferably 1 or more, and preferably 10 or less, more preferably 5 or less, still more preferably 2 or less, as the volume ratio of the washing solvent to the amount of the mixed dispersion of the quantum dot dispersion and the halogen element-containing substance raw material solution. From the viewpoints of ease of production, cost, storage stability of the dispersion, improvement of photoelectric conversion efficiency and the like, the filter pore size at the time of filtration is preferably 0.1 µm or more, more preferably 0.2 µm or more, and preferably 1 µm or less, more preferably 0.5 µm or less. The filter material is preferably a hydrophobic material, more preferably polytetrafluoroethylene (PTFE).

It is preferable to obtain a dispersion containing a quantum dot and one or more members selected from a bulk semiconductor and its precursor, via the step (step 2) of mixing the quantum dot solid obtained in step 1 and a solution or mixed solution containing one or more substances selected from a bulk semiconductor and its precursor.

The dispersion containing the bulk semiconductor (for example, perovskite compound) and/or its precursor and the quantum dots preferably contains a solvent in view of film-forming property, cost, storage stability, and excellent performance (for example, photoelectric conversion characteristics). Examples of the solvent include esters (methyl formate, ethyl formate, etc.), ketones (γ-butyrolactone, N-methyl-2-pyrrolidone, acetone, dimethyl ketone, diisobutyl ketone, etc.), ethers (diethyl ether, methyl tert-butyl ether, dimethoxymethane, 1,4-dioxane, tetrahydrofuran, etc.), alcohols (methanol, ethanol, 2-propanol, tert-butanol, methoxypropanol, diacetone alcohol, cyclohexanol, 2-fluoroethanol, 2,2,2-trifluoroethanol, 2,2,3,3-tetrafluoro-1-propanol, etc.), glycol ethers (cellosolves), amide type solvents (N,N-dimethylformamide, acetamide, N,N-dimethylacetamide, etc.), nitrile type solvents (acetonitrile, isobutyronitrile, propionitrile, methoxyacetonitrile etc.), carbonate type solvents (ethylene carbonate, propylene carbonate, etc.), halogenated hydrocarbons (methylene chloride, dichloromethane, chloroform, etc.), hydrocarbons, dimethylsulfoxide, and the like.

The solvent of the dispersion is preferably a polar solvent, more preferably at least one solvent selected from ketones, amide type solvents, and dimethylsulfoxide (DMSO), still more preferably amide type solvents, even still more preferably N,N-dimethylformamide, from the viewpoints of film forming properties, cost, storage stability, and expression of excellent performance (for example, photoelectric conversion characteristics).

From the viewpoints of film-forming property, cost, storage stability, and expression of excellent performance (for example, photoelectric conversion characteristics), the metal concentration of the bulk semiconductor (for example, perovskite compound) and/or its precursor in the dispersion is preferably 0.1 mol/L or more, more preferably 0.2 mol/L or more, still more preferably 0.3 mol/L or more, and preferably 1.5 mol/L or less, more preferably 1.0 mol/L or less, still more preferably 0.5 mol/L or less, still more preferably 0.4 mol/L or less.

From the viewpoints of film-forming property, cost, storage stability, and expression of excellent performance (for example, photoelectric conversion characteristics), the solid content concentration of the quantum dots in the dispersion is preferably 10 mg/mL or more, more preferably 50 mg/mL or more, still more preferably 70 mg/mL or more, and preferably 300 mg/mL or less, more preferably 200 mg/mL or less, still more preferably 130 mg/mL or less.

The method of preparing the dispersion is not particularly limited, but from the viewpoints of ease of production, cost, storage stability of the dispersion, improvement of photoelectric conversion efficiency and the like, the mixing temperature is preferably 0°C or more, more preferably 10°C or more, still more preferably 20°C or more, and preferably 50°C or less, more preferably 40°C or less, still more preferably 30°C or less. In addition, from the same viewpoint, the mixing time is preferably more than 0 hour, more preferably 0.1 hours or more, and preferably 72 hours or less, more preferably 24 hours or less, still more preferably 1 hour or less.

The dispersion which has been filtered to remove coarse particles is preferable, and from the viewpoints of ease of production, cost, storage stability of the dispersion, improvement of photoelectric conversion efficiency and the like, the filter pore diameter at the time of filtration is preferably 0.1 µm or more, more preferably 0.2 µm or more, and preferably 1 µm or less, more preferably 0.5 µm or less. The filter material is preferably a hydrophobic material, more preferably polytetrafluoroethylene (PTFE).

The step (step 3) of obtaining a light absorption layer from the dispersion obtained in step 2 is preferably a wet process such as applying (coating) the dispersion obtained in step 2 onto a substrate, said wet process including a gravure coating method, a bar coating method, a printing method, a spraying method, a spin coating method, a dipping method, a die coating method, etc. From the viewpoints of ease of production, cost, and expression of excellent performance (for example, photoelectric conversion characteristics), a spin coating method is preferable. The maximum rotation speed of the spin coater in the spin coating method is preferably 500 rpm or more, more preferably 1000 rpm or more, still more preferably 2000 rpm or more, and preferably 6000 rpm or less, more preferably 5000 rpm or less, still more preferably 4000 rpm or less.

In addition, from the viewpoint of ease of production, cost, improvement of photoelectric conversion characteristics and the like, after the dispersion liquid is applied onto the substrate, a poor solvent of the bulk semiconductor may be applied or dropped to improve the crystal deposition rate of the bulk semiconductor. The poor solvent is preferably toluene, chlorobenzene, dichloromethane, or a mixed solvent thereof.

However, since the dispersion liquid contains the quantum dots, crystal growth of the bulk semiconductor is inhibited. Accordingly, voids are likely to be generated in the light absorption layer in step 3 as compared with a case where no quantum dots are contained. Furthermore, when the poor solvent is applied or dropped immediately after the dispersion liquid is applied onto the substrate, a large number of crystal nuclei of the bulk semiconductor are generated, and the supplied amount of raw material per crystal nucleus decreases, so that crystal growth is inhibited. As a result, generation of voids becomes remarkable. Therefore, it is preferable to avoid the generation of voids by minimizing the generation of crystal nuclei of the bulk semiconductor and preferentially growing the minimum crystal nuclei. In conclusion, when the poor solvent is applied or dropped, it is preferable to apply or drop the poor solvent after crystal growth of the bulk semiconductor proceeds to some extent. Specifically, in order to lower the porosity of the light absorption layer to 10% or less, for example, at 25°C, it is preferable to apply or drop the poor solvent 21 seconds or later after the dispersion liquid is applied onto the substrate, more preferably 22 seconds or later, still more preferably 23 seconds or later, further preferably 24 seconds or later. Alternatively, in order to lower the porosity of the light absorption layer to 10% or less, it is preferable not to apply or drop the poor solvent.

As a drying method in the wet process, for example, a thermal drying, an air stream drying, a vacuum drying and the like can be mentioned, from the viewpoints of ease of production, cost, and expression of excellent performance (for example, photoelectric conversion characteristics), and the thermal drying is preferable. The temperature of the thermal drying is preferably 60°C or more, more preferably 80°C or more, still more preferably 90°C or more, from the viewpoint of expression of excellent performance (e.g. photoelectric conversion characteristics), and preferably 200°C or less, more preferably 150°C or less, still more preferably 120°C or less, still more preferably 110°C or less, from the same viewpoint and in view of cost. The time for thermal drying is preferably 1 minute or more, more preferably 5 minutes or more, still more preferably 8 minutes or more, from the viewpoint of expression of excellent performance (for example, photoelectric conversion characteristics), and preferably 120 minutes or less, more preferably 60 minutes or less, still more preferably 20 minutes or less, still more preferably 12 minutes or less, from the same viewpoint and in view of cost.

### <Photoelectric Conversion Element>

The photoelectric conversion element of the present invention has the light absorption layer. In the photoelectric conversion element of the present invention, the configuration other than the light absorption layer is not particularly limited, and a configuration of a known photoelectric conversion element can be applied. In addition, the photoelectric conversion element of the present invention can be manufactured by a known method, except for the light absorption layer.

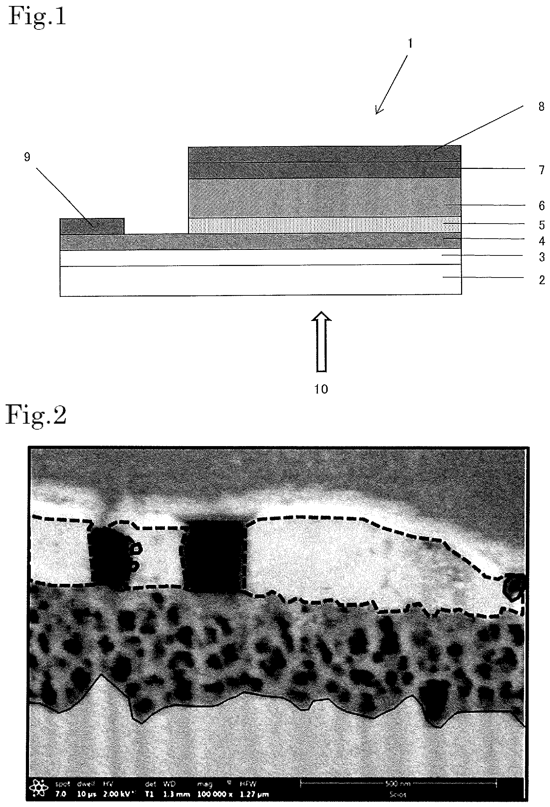

Hereinafter, the structure and manufacturing method of the photoelectric conversion element of the present invention will be described with reference to Fig. 1, but Fig. 1 is merely an example, and the present invention is not limited to the embodiment shown in Fig. 1.

Fig. 1 is a schematic sectional view showing an example of a structure of a photoelectric conversion element of the present invention. A photoelectric conversion element 1 has a structure in which a transparent substrate 2, a transparent conductive layer 3, a blocking layer 4, a porous layer 5, a light absorption layer 6, and a hole transport layer 7 are sequentially laminated. A transparent electrode substrate on the incident side of light 10 is composed of the transparent substrate 2 and the transparent conductive layer 3, and the transparent conductive layer 3 is bonded to an electrode (negative electrode) 9 which is a terminal for electrically connecting to an external circuit. In addition, the hole transport layer 7 is bonded to an electrode (positive electrode) 8 which serves as a terminal for electrically connecting to an external circuit.

As the material of the transparent substrate 2, any material may be used as long as it has strength, durability and light permeability, and synthetic resin and glass can be used for such a purpose. Examples of the synthetic resin include thermoplastic resins such as polyethylene naphthalate (PEN) film, polyethylene terephthalate (PET), polyester, polycarbonate, polyolefin, polyimide, and fluorine resin. From the viewpoints of strength, durability, cost and the like, it is preferable to use a glass substrate.

As the material of the transparent conductive layer 3, for example, indium-added tin oxide (ITO), fluorine-added tin oxide (FTO), tin oxide (SnO₂), indium zinc oxide (IZO), zinc oxide (ZnO), a polymer material having high conductivity and the like can be mentioned. Examples of the polymer material include polyacetylene type polymer materials, polypyrrole type polymer materials, polythiophene type polymer materials, and polyphenylenevinylene type polymer materials. As the material of the transparent conductive layer 3, a carbon-based thin film having high conductivity can also be used. Examples of a method for forming the transparent conductive layer 3 include a sputtering method, a vapor deposition method, a method of coating a dispersion, and the like.

Examples of the material of the blocking layer 4 include titanium oxide, aluminum oxide, silicon oxide, niobium oxide, tungsten oxide, tin oxide, zinc oxide, and the like. Examples of a method for forming the blocking layer 4 include a method of directly sputtering the above material on the transparent conductive layer 3 and a spray pyrolysis method. In addition, there is a method wherein a solution in which the above material is dissolved in a solvent or a solution in which a metal hydroxide that is a precursor of a metal oxide is dissolved is coated on the transparent conductive layer 3, dried, and baked as necessary. Examples of the coating method include gravure coating, bar coating, printing, spraying, spin coating, dipping, die coating, and the like.

The porous layer 5 is a layer having a function of supporting the light absorption layer 6 on its surface. In order to increase the light absorption efficiency in the solar cell, it is preferable to increase the surface area of the portion receiving light. By providing the porous layer 5, it is possible to increase the surface area of such a light-receiving portion.

Examples of the material of the porous layer 5 include a metal oxide, a metal chalcogenide (for example, a sulfide and a selenide), a compound having a perovskite type crystal structure (excluding the light absorber described above), a silicon oxide (for example, silicon dioxide and zeolite), and carbon nanotubes (including carbon nanowires and carbon nanorods), and the like.

Examples of the metal oxide include oxides of titanium, tin, zinc, tungsten, zirconium, hafnium, strontium, indium, cerium, yttrium, lanthanum, vanadium, niobium, aluminum, tantalum, and the like, and examples of the metal chalcogenide include zinc sulfide, zinc selenide, cadmium sulfide, cadmium selenide, and the like.

Examples of the compound having a perovskite type crystal structure include strontium titanate, calcium titanate, barium titanate, lead titanate, barium zirconate, barium stannate, lead zirconate, strontium zirconate, strontium tantalate, potassium niobate, bismuth ferrate, barium strontium titanate, barium lanthanum titanate, calcium titanate, sodium titanate, bismuth titanate, and the like.

The material for forming the porous layer 5 is preferably used as fine particles, more preferably as a dispersion containing fine particles. Examples of a method for forming the porous layer 5 include a wet method, a dry method, and other methods (for example, methods described in Chemical Review, Vol. 110, page 6595 (2010)). In these methods, it is preferable to coating the surface of the blocking layer 4 with a dispersion (paste), followed by baking. By baking, the fine particles can be brought into close contact with each other. Examples of coating methods include gravure coating method, bar coating method, printing method, spraying method, spin coating method, dipping method, die coating method, and the like.

The light absorption layer 6 is the above-described Light absorption layer of the present invention. A method of forming the light absorption layer 6 is not particularly limited, and, for example, there is preferably mentioned a method based on a so-called wet process in which a dispersion containing the bulk semiconductor (for example, perovskite compound) and/or its precursor and the quantum dots is prepared and the prepared dispersion is coated on the surface of the porous layer 5, and is dried. From the viewpoints of ease of production, cost, storage stability of the dispersion, improvement of photoelectric conversion efficiency and the like, a manufacturing method including step 1, step 2 and step 3 is preferable as a method of forming the light absorption layer 6.

As a material of the hole transport layer 7, there can be mentioned, for example, a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine-based compound, a porphyrin-based compound, a phthalocyanine-based compound, a polythiophene derivative, a polypyrrole derivative, a polyparaphenylene vinylene derivative, and the like. Examples of a method for forming the hole transport layer 7 include a coating method, a vacuum vapor deposition method and the like. Examples of the coating method include a gravure coating method, a bar coating method, a printing method, a spray method, a spin coating method, a dipping method, a die coating method, and the like.

As the material of the electrode (positive electrode) 8 and the electrode (negative electrode) 9, there can be mentioned, for example, metals such as aluminum, gold, silver and platinum; conductive metal oxides such as indium tin oxide (ITO), indium zinc oxide (IZO), and zinc oxide (ZnO); organic conductive materials such as conductive polymers; and carbon-based materials such as nanotubes. Examples of a method for forming the electrode (positive electrode) 8 and the electrode (negative electrode) 9 include a vacuum vapor deposition method, a sputtering method, a coating method, and the like.

### <Intermediate-Band Solar Cell>

The intermediate-band solar cell of the present invention has the photoelectric conversion element. In the intermediate-band solar cell of the present invention, the configuration other than the light absorption layer is not particularly limited, and a known solar cell configuration can be applied.

The present invention and preferred embodiments of the present invention are described below.
<1> A light absorption layer, wherein quantum dots are dispersed in a matrix of a bulk semiconductor having a band gap energy of 2.0 eV or more and 3.0 eV or less, and the light absorption layer has an intermediate-band and has a porosity of 10% or less.
<2> The light absorption layer according to <1>, wherein the external quantum efficiency difference of the light absorption layer at 820 nm is preferably 0.0005% or more, more preferably 0.005% or more, still more preferably 0.05% or more.
<3> The light absorption layer according to <1> or <2>, wherein the external quantum efficiency difference of the light absorption layer at 1240 nm is preferably 0.0002% or more, more preferably 0.002% or more, still more preferably 0.02% or more.
<4> The light absorption layer according to <1>, wherein
   preferably, the external quantum efficiency difference of the light absorption layer at 820 nm is 0.0005% or more, and the external quantum efficiency difference of the light absorption layer at 1240 nm is 0.0002% or more,
   more preferably, the external quantum efficiency difference of the light absorption layer at 820 nm is 0.005% or more, and the external quantum efficiency difference of the light absorption layer at 1240 nm is 0.002% or more,
   still more preferably, the external quantum efficiency difference of the light absorption layer at 820 nm is 0.05% or more, and the external quantum efficiency difference of the light absorption layer at 1240 nm is 0.02% or more.
<5> The light absorption layer according to any one of <1> to <4>, wherein the energy difference between the valence band of the bulk semiconductor and the intermediate-band is preferably 1.1 eV or more, more preferably 1.2 eV or more, still more preferably 1.3 eV or more, still more preferably 1.4 eV or more, and preferably 2.0 eV or less, more preferably 1.8 eV or less, still more preferably 1.6 eV or less.
<6> The light absorption layer according to any one of <1> to <5>, wherein the energy difference between the intermediate-band and the conduction band of the bulk semiconductor is preferably 0.5 eV or more, more preferably 0.6 eV or more, still more preferably 0.7 eV or more, and preferably 2.0 eV or less, more preferably 1.5 eV or less, still more preferably 1.0 eV or less, still more preferably 0.9 eV or less.
<7> The light absorption layer according to any one of <1> to <4>, wherein
   preferably, the energy difference between the valence band of the bulk semiconductor and the intermediate-band is 1.1 eV or more and preferably 2.0 eV or less, and the energy difference between the intermediate-band and the conduction band of the bulk semiconductor is 0.5 eV or more and preferably 2.0 eV or less,
   more preferably, the energy difference between the valence band of the bulk semiconductor and the intermediate-band is 1.2 eV or more and preferably 1.8 eV or less, and the energy difference between the intermediate-band and the conduction band of the bulk semiconductor is 0.6 eV or more and preferably 1.5 eV or less,
   still more preferably, the energy difference between the valence band of the bulk semiconductor and the intermediate-band is 1.3 eV or more and preferably 1.6 eV or less, and the energy difference between the intermediate-band and the conduction band of the bulk semiconductor is 0.7 eV or more and preferably 1.0 eV or less,
   even still more preferably, the energy difference between the valence band of the bulk semiconductor and the intermediate-band is 1.4 eV or more and preferably 1.6 eV or less, and the energy difference between the intermediate-band and the conduction band of the bulk semiconductor is 0.7 eV or more and preferably 0.9 eV or less.
<8> The light absorption layer according to any one of <1> to <7>, wherein the bulk semiconductor is preferably an inorganic material or an organic-inorganic composite compound, more preferably an organic-inorganic composite compound, preferably a perovskite compound, more preferably an organic-inorganic composite perovskite compound.
<9> The light absorption layer according to any one of <1> to <7>, wherein the bulk semiconductor is a perovskite compound.
<10> The light absorption layer according to any one of <1> to <9>, wherein the band gap energy of the bulk semiconductor is preferably 2.1 eV or more, more preferably 2.2 eV or more, and preferably 2.9 eV or less, more preferably 2.8 eV or less, still more preferably 2.6 eV or less, still more preferably 2.4 eV or less.
<11> The light absorption layer according to <9> or <10>, wherein the perovskite compound is preferably one or more kinds selected from a compound represented by the following general formula (1) and a compound represented by the following general formula (2), more preferably a compound represented by the following general formula (1).

   RMX₃ (1)

   (R is a monovalent cation, M is a divalent metal cation, and X is a halogen anion.)

   R¹R²R³ₙ₋₁MₙX₃ₙ₊₁ (2)

   (R¹, R² and R³ are each independently a monovalent cation, M is a divalent metal cation, X is a halogen anion, and n is an integer of 1 to 10.)
<12> The light absorption layer according to <9> or <10>, wherein the perovskite compound is a compound represented by the following general formula (1).

   RMX₃ (1)

   (R is a monovalent cation, M is a divalent metal cation, and X is a halogen anion.)
<13> The light absorption layer according to <11> or <12>, wherein R is one or more kinds selected from a cation of the group 1 of the periodic table and an organic cation, the cation of the group 1 of the periodic table is preferably one or more kinds selected from Li⁺, Na⁺, K⁺ and Cs⁺, the organic cation is preferably one or more kinds selected from an ammonium ion which may have a substituent and a phosphonium ion which may have a substituent, the optionally substituted ammonium ion is preferably one or more kinds selected from an alkylammonium ion, a formamidinium ion and an arylammonium ion, more preferably one or more kinds selected from an alkylammonium ion and a formamidinium ion, still more preferably one or more kinds selected from a monoalkylammonium ion and a formamidinium ion, still more preferably one or more kinds selected from a methylammonium ion, an ethylammonium ion, a butylammonium ion and a formamidinium ion, and even still more preferably a methylammonium ion.
<14> The light absorption layer according to <11> or <12>, wherein R is one or more kinds selected from an alkylammonium ion and a formamidinium ion.
<15> The light absorption layer according to <11> or <12>, wherein R is one or more kinds selected from a monoalkylammonium ion and a formamidinium ion.
<16> The light absorption layer according to <11> or <12>, wherein R is one or more kinds selected from a methylammonium ion, an ethylammonium ion, a butylammonium ion and a formamidinium ion.
<17> The light absorption layer according to <11> or <12>, wherein R is a methylammonium ion.
<18> The light absorption layer according to <11>, wherein R¹, R², and R³ are one or more kinds selected from a cation of the group 1 of the periodic table and an organic cation, the cation of the group 1 of the periodic table is preferably one or more kinds selected from Li⁺, Na⁺, K⁺ and Cs⁺, the organic cation is preferably one or more kinds selected from an ammonium ion which may have a substituent and a phosphonium ion which may have a substituent, the optionally substituted ammonium ion is preferably one or more kinds selected from an alkylammonium ion, a formamidinium ion and an arylammonium ion, more preferably one or more kinds selected from an alkylammonium ion and a formamidinium ion, still more preferably a monoalkylammonium ion, even still more preferably one or more kinds selected from a methylammonium ion, an ethylammonium ion, a butylammonium ion, a hexylammonium ion, an octylammonium ion, a decylammonium ion, a dodecyl ammonium ion, a tetradecyl ammonium ion, a hexadecyl ammonium ion, and an octadecyl ammonium ion.
<19> The light absorption layer according to <11> or <18>, wherein n is an integer of 1 to 4.
<20> The light absorption layer according to any one of <11> to <19>, wherein M is preferably one or more kinds selected from Pb²⁺, Sn²⁺, Hg²⁺, Cd²⁺, Zn²⁺, Mn²⁺, Cu²⁺, Ni²⁺, Fe²⁺, Co²⁺, Pd²⁺, Ge²⁺, Y²⁺, and Eu²⁺, more preferably one or more kinds selected from Pb²⁺, Sn²⁺ and Ge²⁺, still more preferably one or more kinds selected from Pb²⁺ and Sn²⁺, still more preferably Pb²⁺.
<21> The light absorption layer according to any one of <11> to <19>, wherein M is Pb²⁺, Sn²⁺ or Ge²⁺.
<22> The light absorption layer according to any one of <11> to <21>, wherein X is preferably one or more kinds selected from a fluorine anion, a chlorine anion, a bromine anion, and an iodine anion, more preferably one or more kinds selected from a fluorine anion, a chlorine anion, and a bromine anion, still more preferably one or more kinds selected from a chlorine anion and a bromine anion, even still more preferably a bromine anion.
<23> The light absorption layer according to any one of <11> to <21>, wherein X is a fluorine anion, a chlorine anion, a bromine anion or an iodine anion.
<24> The light absorption layer according to any one of <11> to <23>, wherein the compound represented by the general formula (1) is preferably one or more kinds selected from CH₃NH₃PbBr₃ and CH(=NH)NH₃PbBr₃, more preferably CH₃NH₃PbBr₃.
<25> The light absorption layer according to any one of <8> to <24>, wherein a crystallite diameter of the perovskite compound of the light absorption layer is preferably 10 nm or more, more preferably 20 nm or more, still more preferably 30 nm or more, still more preferably 40 nm or more, and preferably 1000 nm or less.
<26> The light absorption layer according to any one of <1> to <25>, wherein the quantum dots have a band gap energy of 0.2 eV or more and less than the band gap energy of the bulk semiconductor.
<27> The light absorption layer according to any one of <1> to <25>, wherein a band gap energy of the quantum dot is preferably 0.6 eV or more, more preferably 0.7 eV or more, still more preferably 0.8 eV or more, and preferably 1.6 eV or less, more preferably 1.5 eV or less, still more preferably 1.4 eV or less, still more preferably 1.3 eV or less.
<28> The light absorption layer according to any one of <1> to <27>, wherein a difference between the band gap energy of the bulk semiconductor and the band gap energy of the quantum dot is preferably 0.4 eV or more, more preferably 0.8 eV or more, still more preferably 1.0 eV or more, even still more preferably 1.2 eV or more, and preferably 2.8 eV or less, more preferably 2.0 eV or less, still more preferably 1.6 eV or less, even still more preferably 1.4 eV or less
<29> The light absorption layer according to any one of <1> to <25>, wherein
   preferably, a band gap energy of the quantum dot is 0.6 eV or more and 1.6 eV or less, and a difference between the band gap energy of the bulk semiconductor and the band gap energy of the quantum dot is 0.4 eV or more and 2.8 eV or less,
   more preferably, a band gap energy of the quantum dot is 0.7 eV or more and 1.5 eV or less, and a difference between the band gap energy of the bulk semiconductor and the band gap energy of the quantum dot is 0.8 eV or more and 2.0 eV or less,
   still more preferably, a band gap energy of the quantum dot is 0.8 eV or more and 1.4 eV or less, and a difference between the band gap energy of the bulk semiconductor and the band gap energy of the quantum dot is 1.0 eV or more and 1.6 eV or less,
   even still more preferably, a band gap energy of the quantum dot is 0.8 eV or more and 1.3 eV or less, and a difference between the band gap energy of the bulk semiconductor and the band gap energy of the quantum dot is 1.2 eV or more and 1.4 eV or less.
<30> The light absorption layer according to any one of <1> to <29>, wherein a particle diameter of the quantum dot is preferably 1 nm or more, more preferably 2 nm or more, still more preferably 3 nm or more, and preferably 20 nm or less, more preferably 10 nm or less, still more preferably 5 nm or less.
<31> The light absorption layer according to any one of <1> to <30>, wherein the quantum dots preferably contain Pb element, more preferably PbS or PbSe, still more preferably PbS.
<32> The light absorption layer according to any one of <1> to <31>, wherein the quantum dots are quantum dots containing a halogen element-containing substance.
<33> The light absorption layer according to any one of <1> to <31>, wherein the quantum dots are quantum dots containing an organic compound and a halogen element-containing substance.
<34> The light absorption layer according to <33>, wherein the organic compound is preferably a carboxy group-containing compound or an amino group-containing compound, more preferably a carboxy group-containing compound, still more preferably carboxylic acid, still more preferably fatty acid, still more preferably fatty acid having 8 to 30 carbon atoms, still more preferably fatty acid having 12 to 18 carbon atoms, still more preferably unsaturated fatty acid having 12 to 18 carbon atoms, still more preferably oleic acid.
<35> The light absorption layer according to <33>, wherein the organic compound is oleic acid.
<36> The light absorption layer according to any one of <32> to <35>, wherein a halogen element of the halogen element-containing substance is iodine or bromine.
<37> The light absorption layer according to any one of <32> to <35>, wherein a halogen element of the halogen element-containing substance is iodine.
<38> The light absorption layer according to any one of <32> to <35>, wherein the halogen element-containing substance is iodine.
<39> The light absorption layer according to any one of <8> to <38>, wherein a combination of the perovskite compound and the quantum dot is a combination of compounds containing the same metal element.
<40> The light absorption layer according to any one of <8> to <39>, wherein a combination of the perovskite compound and the quantum dot is a combination of CH₃NH₃PbBr₃ and PbS.
<41> The light absorption layer according to any one of <1> to <40>, wherein a content of the quantum dots in the light absorption layer is preferably 7.5% by mass or more, more preferably 10% by mass or more, still more preferably 15% by mass or more, further preferably 20% by mass or more, and preferably 40% by mass or less, more preferably 30% by mass or less, still more preferably 25% by mass or less.
<42> The light absorption layer according to any one of <1> to <40>, wherein a content of the quantum dots in the light absorption layer is preferably 7.5% by mass or more.
<43> The light absorption layer according to any one of <1> to <40>, wherein a content of the quantum dots in the light absorption layer is preferably 7.5% by mass or more and 40% by mass or less.
<44> The light absorption layer according to any one of <1> to <40>, wherein a content of the quantum dots in the light absorption layer is preferably 10% by mass or more and 30% by mass or less.
<45> The light absorption layer according to any one of <1> to <40>, wherein a content of the quantum dots in the light absorption layer is preferably 15% by mass or more and 25% by mass or less.
<46> The light absorption layer according to any one of <1> to <40>, wherein a content of the quantum dots in the light absorption layer is preferably 20% by mass or more and 25% by mass or less.
<47> The light absorption layer according to any one of <1> to <46>, wherein a porosity of the light absorption layer is 8% or less.
<48> The light absorption layer according to any one of <1> to <46>, wherein a porosity of the light absorption layer is 7% or less.
<49> The light absorption layer according to any one of <1> to <46>, wherein a porosity of the light absorption layer is 6% or less.
<50> The light absorption layer according to any one of <1> to <49>, wherein a thickness of the light absorption layer is preferably 30 nm or more, more preferably 50 nm or more, still more preferably 80 nm or more, and preferably 1000 nm or less, more preferably 800 nm or less, still more preferably 600 nm or less, even still more preferably 500 nm or less.
<51> A dispersion for manufacturing the light absorption layer according to any one of <1> to <50>, comprising the bulk semiconductor having a band gap energy of 2.0 eV or more and 3.0 eV or less and/or a precursor thereof and the quantum dots.
<52> The dispersion according to <51>, comprising a solvent.
<53> The dispersion according to <51> or <52>, wherein a solid content concentration of the quantum dots in the dispersion is 10 mg/mL or more and preferably 100 mg/mL or less.
<54> A light absorption layer obtained from the dispersion according to any one of <51> to <53>.
<55> A method for manufacturing a light absorption layer having an intermediate-band and having a porosity of 10% or less, wherein quantum dots are dispersed in a matrix of a bulk semiconductor, which method comprises the following step 1, step 2, and step 3:
   (step 1) a step of ligand-exchanging the organic ligand of an organic ligand-containing quantum dot to a halogen element-containing substance to obtain a quantum dot solid containing the halogen element-containing substance as a ligand,
   (step 2) a step of obtaining a dispersion by mixing the quantum dot solid obtained in step 1 with a solution or mixed solution containing one or more substances selected from a bulk semiconductor and a precursor thereof,
   (step 3) a step of obtaining a light absorption layer from the dispersion obtained in step 2.
<56> The method for manufacturing the light absorption layer according to <55>, wherein the ligand exchange in step 1 is preferably performed in a dispersion, more preferably performed by mixing a dispersion of the quantum dots containing the organic ligand and a raw material solution of the halogen element-containing substance.
<57> The method for manufacturing the light absorption layer according to <56>, wherein the halogen element-containing substance raw material used for the ligand exchange is preferably one or more kinds selected from methylammonium iodide (methylamine hydroiodide), ammonium iodide, iodine, methylammonium bromide (methylamine hydrobromide), ammonium bromide, and bromine, more preferably one or more kinds selected from methylammonium iodide (methylamine hydroiodide), ammonium iodide, methylammonium bromide (methylamine hydrobromide), and ammonium bromide, still more preferably one or more kinds selected from methylammonium iodide (methylamine hydroiodide) and methylammonium bromide (methylamine hydrobromide), even still more preferably methylammonium iodide (methylamine hydroiodide).
<58> The method for manufacturing the light absorption layer according to <56>, wherein the halogen element-containing substance raw material used for the ligand exchange is methylammonium iodide (methylamine hydroiodide).
<59> The method for manufacturing the light absorption layer according to any one of <56> to <58>, wherein a mixing amount of the halogen element-containing substance raw material used for ligand exchange is preferably such that the molar ratio of the halogen element to the organic compound on the quantum dot surface is preferably 0.1 or more, more preferably 1 or more, still more preferably 1.5 or more, and preferably 10 or less, more preferably 8 or less, still more preferably 5 or less, still more preferably 3 or less.
<60> The method for manufacturing the light absorption layer according to any one of <56> to <59>, wherein a solvent used for ligand exchange is preferably a mixed solvent of a solvent capable of dispersing quantum dots and a solvent capable of dissolving a halogen element-containing substance raw material, the solvent for dispersing the quantum dots is preferably one or more non-(low)polar organic solvents selected from toluene, hexane, and octane, and is more preferably toluene, the solvent for dissolving the halogen element-containing substance raw material is preferably at least one aprotic polar organic solvent selected from N,N-dimethylformamide, dimethyl sulfoxide, and γ-butyrolactone, more preferably N,N-dimethylformamide.
<61> The method for manufacturing the light absorption layer according to any one of <56> to <60>, wherein a solid content concentration of the quantum dots in the quantum dot dispersion to be mixed at the time of ligand exchange is preferably 10 mg/mL or more, more preferably 50 mg/mL or more, still more preferably 80 mg/mL or more, and preferably 1000 mg/mL or less, more preferably 500 mg/mL or less, still more preferably 200 mg/mL or less, still more preferably 120 mg/mL or less.
<62> The method for manufacturing the light absorption layer according to any one of <56> to <60>, wherein a solid content concentration of the quantum dots in the quantum dot dispersion to be mixed at the time of ligand exchange is 10 mg/mL or more and 1000 mg/mL or less.
<63> The method for manufacturing the light absorption layer according to any one of <56> to <60>, wherein a solid content concentration of the quantum dots in the quantum dot dispersion to be mixed at the time of ligand exchange is 50 mg/mL or more and 500 mg/mL or less.
<64> The method for manufacturing the light absorption layer according to any one of <56> to <60>, wherein a solid content concentration of the quantum dots in the quantum dot dispersion to be mixed at the time of ligand exchange is 80 mg/mL or more and 120 mg/mL or less.
<65> The method for manufacturing the light absorption layer according to any one of <56> to <64>, wherein a concentration of the halogen element-containing substance raw material in the halogen element-containing substance raw material solution to be mixed at the time of ligand exchange is preferably 0.01 mol/L or more, more preferably 0.1 mol/L or more, still more preferably 0.2 mol/L or more, and preferably 1 mol/L or less, more preferably 0.5 mol/L or less, still more preferably 0.3 mol/L or less.
<66> The method for manufacturing the light absorption layer according to any one of <56> to <64>, wherein a concentration of the halogen element-containing substance raw material in the halogen element-containing substance raw material solution to be mixed at the time of ligand exchange is 0.01 mol/L or more and 1 mol/L or less.
<67> The method for manufacturing the light absorption layer according to any one of <56> to <64>, wherein a concentration of the halogen element-containing substance raw material in the halogen element-containing substance raw material solution to be mixed at the time of ligand exchange is 0.1 mol/L or more and 0.5 mol/L or less.
<68> The method for manufacturing the light absorption layer according to any one of <56> to <64>, wherein a concentration of the halogen element-containing substance raw material in the halogen element-containing substance raw material solution to be mixed at the time of ligand exchange is 0.2 mol/L or more and 0.3 mol/L or less.
<69> The method for manufacturing the light absorption layer according to any one of <56> to <68>, wherein a method of mixing the quantum dot dispersion and the halogen element-containing substance raw material solution at the time of ligand exchange is a continuous method or a dropping method (semi-continuous method).
<70> The method for manufacturing the light absorption layer according to any one of <56> to <68>, wherein a method of mixing the quantum dot dispersion and the halogen element-containing substance raw material solution at the time of ligand exchange is a dropping method (semi-continuous method).
<71> The method for manufacturing the light absorption layer according to <69> or <70>, wherein the continuous method is a method of mixing the raw material solution of the halogen element-containing substance in the quantum dot dispersion, and a mixing speed is preferably 25 µl/sec or less, more preferably 5 µl/sec or less, still more preferably 3 µl/sec or less, and preferably 0.2 µl/sec or more, more preferably 0.4 µl/sec or more, still more preferably 1.5 µl/sec or more.
<72> The method for manufacturing the light absorption layer according to <69> or <70>, wherein the dropping method is a method of dropping the raw material solution of the halogen element-containing substance to the quantum dot dispersion, and a dropping rate is preferably 1 drop/1 second or less, more preferably 1 drop/5 seconds or less, still more preferably 1 drop/8 seconds or less, and preferably 1 drop/100 seconds or more, more preferably 1 drop/50 seconds or more, still more preferably 1 drop/15 seconds or more.
<73> The method for manufacturing the light absorption layer according to any one of <56> to <72>, wherein a time allowed to stand still the mixture after mixing the quantum dot dispersion and the halogen element-containing substance raw material solution is preferably 0.1 hours or more, more preferably 1 hour or more, still more preferably 10 hours or more, and preferably 100 hours or less, more preferably 48 hours or less, still more preferably 24 hours or less.
<74> The method for manufacturing the light absorption layer according to any one of <56> to <73>, wherein a step for obtaining a quantum dot solid having a halogen element-containing substance as the ligands after ligand exchange is a step containing adding a washing solvent to a mixture dispersion of a quantum dot dispersion and a halogen element-containing substance raw material solution and filtering the resulting mixture to remove the organic compound coordinated on the surface of the quantum dot, the excess halogen element-containing substance raw material and the solvent, the washing solvent is preferably an organic solvent in which any quantum dots before and after ligand exchange are hardly dispersed and an organic compound and a halogen element-containing substance are soluble, more preferably an alcohol solvent, still more preferably methanol.
<75> The method for manufacturing the light absorption layer according to <74>, wherein an amount of the washing solvent is preferably 0.1 or more, more preferably 0.5 or more, still more preferably 1 or more, and preferably 10 or less, more preferably 5 or less, still more preferably 2 or less, as the volume ratio of the washing solvent to the amount of the mixed dispersion of the quantum dot dispersion and the halogen element-containing substance raw material solution.
<76> The method for manufacturing the light absorption layer according to <74> or <75>, wherein a filter pore size at the time of filtration is preferably 0.1 µm or more, more preferably 0.2 µm or more, and preferably 1 µm or less, more preferably 0.5 µm or less, and a filter material is preferably a hydrophobic material, more preferably polytetrafluoroethylene (PTFE).
<77> The method for manufacturing the light absorption layer according to any one of <55> to <76>, wherein the dispersion preferably contains a solvent.
<78> The method for manufacturing the light absorption layer according to <77>, wherein the solvent is preferably a polar solvent, more preferably at least one solvent selected from ketones, amide type solvents, and dimethylsulfoxide, still more preferably amide type solvents, even still more preferably N,N-dimethylformamide.
<79> The method for manufacturing the light absorption layer according to any one of <55> to <78>, wherein a metal concentration of the bulk semiconductor and/or its precursor in the dispersion is preferably 0.1 mol/L or more, more preferably 0.2 mol/L or more, still more preferably 0.3 mol/L or more, and preferably 1.5 mol/L or less, more preferably 1.0 mol/L or less, still more preferably 0.5 mol/L or less, still more preferably 0.4 mol/L or less.
<80> The method for manufacturing the light absorption layer according to any one of <55> to <78>, wherein a metal concentration of the bulk semiconductor and/or its precursor in the dispersion is 0.1 mol/L or more and 1.5 mol/L or less.
<81> The method for manufacturing the light absorption layer according to any one of <55> to <78>, wherein a metal concentration of the bulk semiconductor and/or its precursor in the dispersion is 0.2 mol/L or more and 1.0 mol/L or less.
<82> The method for manufacturing the light absorption layer according to any one of <55> to <78>, wherein a metal concentration of the bulk semiconductor and/or its precursor in the dispersion is 0.3 mol/L or more and 1.0 mol/L or less.
<83> The method for manufacturing the light absorption layer according to any one of <55> to <78>, wherein a metal concentration of the bulk semiconductor and/or its precursor in the dispersion is 0.3 mol/L or more and 0.4 mol/L or less.
<84> The method for manufacturing the light absorption layer according to any one of <55> to <83>, wherein a solid content concentration of the quantum dots in the dispersion is preferably 10 mg/mL or more, more preferably 50 mg/mL or more, still more preferably 70 mg/mL or more, and preferably 300 mg/mL or less, more preferably 200 mg/mL or less, still more preferably 130 mg/mL or less.
<85> The method for manufacturing the light absorption layer according to any one of <55> to <83>, wherein a solid content concentration of the quantum dots in the dispersion is 10 mg/mL or more and 300 mg/mL or less.
<86> The method for manufacturing the light absorption layer according to any one of <55> to <83>, wherein a solid content concentration of the quantum dots in the dispersion is 50 mg/mL or more and 200 mg/mL or less.
<87> The method for manufacturing the light absorption layer according to any one of <55> to <83>, wherein a solid content concentration of the quantum dots in the dispersion is 70 mg/mL or more and 130 mg/mL or less.
<88> The method for manufacturing the light absorption layer according to any one of <55> to <87>, wherein a mixing temperature when preparing the dispersion is preferably 0°C or more, more preferably 10°C or more, still more preferably 20°C or more, and preferably 50°C or less, more preferably 40°C or less, still more preferably 30°C or less.
<89> The method for manufacturing the light absorption layer according to any one of <55> to <88>, wherein the dispersion is filtered to remove coarse particles, a filter pore diameter at the time of filtration is preferably 0.1 µm or more, more preferably 0.2 µm or more, and preferably 1 µm or less, more preferably 0.5 µm or less, and a filter material is preferably a hydrophobic material, more preferably polytetrafluoroethylene (PTFE).
<90> The method for manufacturing the light absorption layer according to any one of <55> to <89>, wherein the step 3 is preferably a wet process, more preferably a spin coating method, and a maximum rotation speed of a spin coater in the spin coating method is preferably 500 rpm or more, more preferably 1000 rpm or more, still more preferably 2000 rpm or more, and preferably 6000 rpm or less, more preferably 5000 rpm or less, still more preferably 4000 rpm or less.
<91> The method for manufacturing the light absorption layer according to any one of <55> to <90>, wherein it is preferable to apply or drop a poor solvent 21 seconds or later after the dispersion is applied onto a substrate, more preferably 22 seconds or later, still more preferably 23 seconds or later, further preferably 24 seconds or later.
<92> The method for manufacturing the light absorption layer according to <91>, wherein the poor solvent is preferably toluene, chlorobenzene, dichloromethane, or a mixed solvent thereof.
<93> The method for manufacturing the light absorption layer according to any one of <55> to <90>, wherein it is preferable not to apply or drop a poor solvent after the dispersion is applied onto a substrate.
<94> The method for manufacturing the light absorption layer according to any one of <90> to <93>, wherein a drying method in the wet process is preferably a thermal drying, a temperature of the thermal drying is preferably 60 °C or more, more preferably 80°C or more, still more preferably 90°C or more, and preferably 200°C or less, more preferably 150°C or less, still more preferably 120°C or less, still more preferably 110°C or less, and a time for the thermal drying is preferably 1 minute or more, more preferably 5 minutes or more, still more preferably 8 minutes or more, and preferably 120 minutes or less, more preferably 60 minutes or less, still more preferably 20 minutes or less, still more preferably 12 minutes or less.
<95> A photoelectric conversion element having the light absorption layer according to any one of <1> to <50> and <54>.
<96> An intermediate-band solar cell having the photoelectric conversion element according to <95>.

### EXAMPLES

Hereinafter, the present invention will be described specifically based on Examples. Unless otherwise indicated in the table, the content of each component is % by mass. In addition, the evaluation/measurement method are as follows. In addition, unless otherwise noted, the implementation and measurement were carried out at 25°C and normal pressure (101.3 kPa).

### <external quantum efficiency difference>

The external quantum efficiency difference (ΔEQE) was obtained by measuring the quantum efficiency (EQE) in the presence or absence of infrared-bias light irradiation using an optical chopper in a spectral response measurement system (CEP-1500, manufactured by Bunkoukeiki Co., Ltd.) and determining the difference (ΔEQE) between the EQE at the time of infrared bias light irradiation and the EQE at the time of no infrared bias light irradiation. Infrared bias light obtained by passing a pseudo-sunlight source of a xenon lamp with AM 1.5 filter through a long pass filter of 850 nm and 1400 nm was used. The modulation frequency of the infrared chopper was 5 Hz. Measurement was carried out by an alternating current method under a mask with a light irradiation area of 0.0361 cm² in the wavelength range of 300 to 1300 nm. The external quantum efficiency differences (ΔEQE) at wavelengths of 820 nm and 1240 nm were determined.

### <Absorption Spectrum>

Using a UV-Vis spectrophotometer (SolidSpec-3700, manufactured by Shimadzu Corporation) under the conditions of a scanning speed of medium speed, a sample pitch of 1 nm, a slit width of 20, and an integrating sphere detector unit, the absorption spectrum of the light absorption layer was measured in the range of 300 to 1600 nm on a sample before applying the hole transport material. Background measurement was carried out with a fluorine-doped tin oxide (FTO) substrate (manufactured by Asahi Glass Fabritec Co., Ltd., 25 × 25 × 1.8 mm).

The absorption spectrum of the PbS quantum dot dispersion was similarly measured in a dispersion having a concentration of 0.1 mg/mL or more and 1 mg/mL or less of PbS quantum dot solid using a 1 cm square quartz cell.

In the case of PbS quantum dot in which oleic acid was coordinated, hexane was used as a dispersion solvent, and in the case of PbS quantum dot in which iodine was coordinated, N,N-dimethylformamide (DMF) was used as a dispersion solvent.

Note that the absorption spectrum of the horizontal axis representing the wavelength λ and the vertical axis representing the absorbance A was converted into the spectrum of the horizontal axis representing the energy hν and the vertical axis representing (αhν)^{1/2} (α; absorption coefficient), and a straight line was fitted to the rising part of absorption and the intersection of the straight line and the baseline was taken as the band gap energy.

### <X-Ray Diffraction Analysis>

The crystallite diameter of the perovskite compound of the light absorption layer was determined in the range of 5 to 60° on a sample before applying a hole transport material by using a powder X-ray diffractometer (MiniFlex 600, light source Cu Kα, tube voltage 40 kV, tube current 15 mA, manufactured by Rigaku Corporation) under the conditions of a sampling width of 0.02°, a scanning speed of 20°/min, a solar slit (incident) of 5.0°, a divergence slit of 1.250°, a vertical divergence of 13.0 mm, a scattering slit of 13.0 mm, a solar slit (reflection) of 5.0°, and a receiving slit of 13.0 mm. The crystallite diameter of the perovskite compound was calculated at the strongest peak of the perovskite compound using an analysis software (PDXL, ver. 2.6.1.2).

The crystallite diameter (particle size) of the PbS quantum dot was measured similarly in a PbS quantum dot solid on a glass holder and calculated at the cubic (220) peak (2θ=42°) of PbS using an analysis software (PDXL, ver. 2.6.1.2).

### <Composition of PbS Quantum Dot Solid>

The Pb concentration in the PbS quantum dot solid was quantified by high frequency inductively coupled plasma-atomic emission spectroscopy (ICP) after completely dissolving the PbS quantum dot solid in a mixed solution of nitric acid and hydrogen peroxide.

The concentration of oleic acid in the PbS quantum dot solid was quantified by a proton (¹H) nuclear magnetic resonance (NMR) method in a deuterated toluene solvent (99 atom% D, containing 0.03 vol% TMS, manufactured by Sigma-Aldrich Japan K.K.) in the case of PbS quantum dots in which oleic acid was coordinated as an internal standard substance. Measurement was performed using an NMR device (VNMRS 400, manufactured by Agilent) under the conditions of a resonance frequency of 400 MHz, a delay time of 60 seconds, and 32 times integrations. The oleic acid concentration in the PbS quantum dot solid was determined from the ratio of the integrated value of the vinyl proton of oleic acid (5.5 ppm vs. TMS) to the integrated value of the dibromomethane (3.9 ppm vs. TMS).

### <Synthesis of PbS Quantum Dot Coordinated with Oleic Acid>

Into a 50 mL three-necked flask were placed 0.45 g of lead oxide (manufactured by Wako Pure Chemical Industries, Ltd.), 10 g of octadecene (manufactured by Sigma-Aldrich Japan K.K.) and 1.34 g of oleic acid (manufactured by Sigma-Aldrich Japan K.K.), and the mixture was stirred at 80°C for 2 hours to prepare a Pb source solution. After evacuating the inside of the reaction system with a vacuum pump and introducing nitrogen gas to return to atmospheric pressure, the reaction system was further stirred at 110°C for 30 minutes. On the other hand, 210 µL of 1,1,1,3,3,3-hexamethyldisilatiane (manufactured by Tokyo Chemical Industry Co., Ltd.) was dissolved in 4 mL of octadecene to prepare an S source solution. The S source solution was injected at once with a syringe into the Pb source solution at 110°C with stirring under nitrogen gas to produce a PbS quantum dot coordinated with oleic acid. After stopping the reaction by adding a large excess of acetone, the supernatant was removed by centrifugation (CR21 GIII, R15A rotor, manufactured by Hitachi Koki K.K.) at 2,500 rpm for 2 minutes, and the precipitate was dried under reduced pressure, whereby a PbS quantum dot solid in which oleic acid was coordinated was obtained.

Each concentration in the PbS quantum dot solid in which oleic acid was coordinated was Pb=66% by mass, oleic acid=22% by mass, and oleic acid/Pb molar ratio=0.25. It was found that the crystallite diameter was 2.7 nm from the X-ray diffraction result, the absorption edge wavelength was 1070 nm from the absorption spectrum, the absorption peak wavelength was 970 nm (peak absorbance 0.501 at a solid content concentration of 1 mg/mL in a hexane dispersion).

### <Synthesis of PbS Quantum Dot Coordinated with Iodine>

The PbS quantum dot solid (0.20 g) in which oleic acid was coordinated was dispersed in 2 mL of toluene (dehydrated, manufactured by Wako Pure Chemical Industries, Ltd.) to obtain a black transparent dispersion. Meanwhile, 0.053 g of methylamine hydroiodide (CH₃NH₃I, manufactured by Tokyo Chemical Industry Co., Ltd.) was dissolved in 0.5 mL of DMF (dehydrated, manufactured by Wako Pure Chemical Industries, Ltd.) and 1 mL of toluene (dehydrated, manufactured by Wako Pure Chemical Industries, Ltd.) (molar ratio of CH₃NH₃I/oleic acid of 2). The CH₃NH₃I solution was added dropwise to the PbS quantum dot dispersion at a drop rate of 1 drop/10 seconds (drop time: 11 minutes) at room temperature (25°C) under a nitrogen atmosphere (in a glove box) without stirring and allowed to stand for 18 hours. After further addition of 5 mL of methanol, followed by mixing, the reaction mixture was subjected to a filtration with a filter (pore size 0.2 µm, PTFE material), and then dried to obtain a PbS quantum dot solid in which iodine was coordinated.

### <Measurement of porosity>

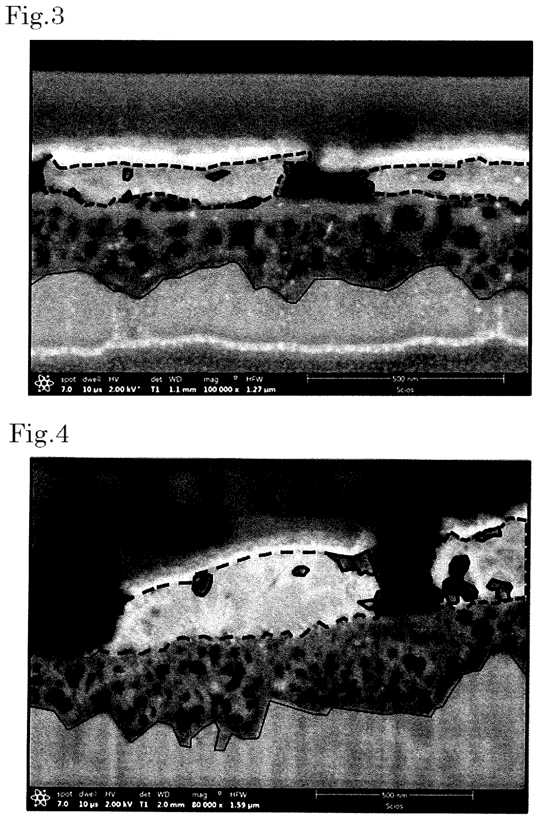

First, a cross section of the light absorption layer was observed using cryoFIB-SEM (Scios DualBeam, manufactured by FEI) (Figs. 2 to 4). In order to protect the surface, platinum palladium coating was performed twice for 120 seconds, and a carbon protective film was formed on the site for observation in the FIB-SEM apparatus. FIB cross section processing was performed at 30 kV and 0.3 nA, Z contrast was detected by reflected electrons, and observation was performed at an acceleration voltage of 2 kV, WD of 1 mm, and a magnification of 100,000 times.

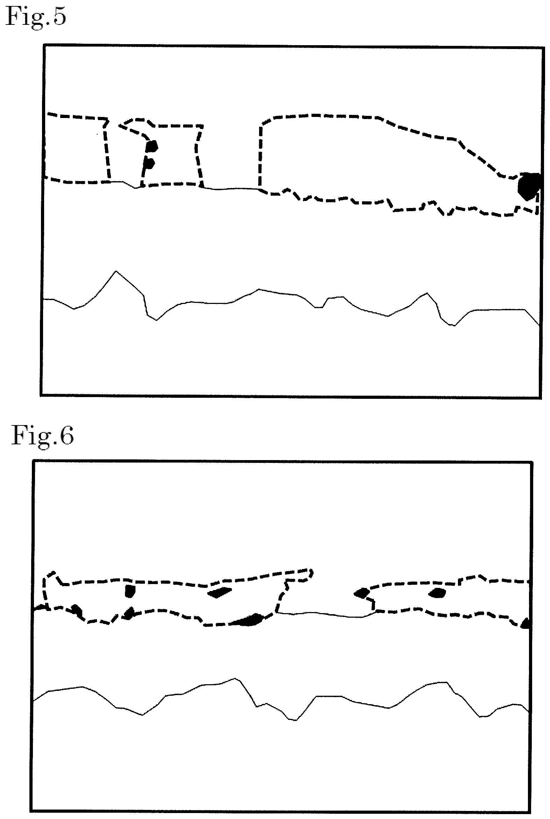

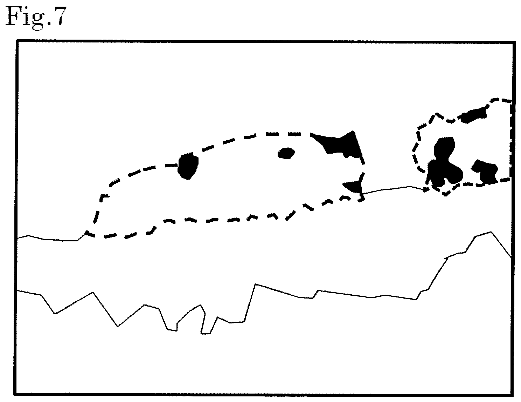

Next, binarization processing was performed at a threshold of 120 using image analysis software (WinROOF2013 manufactured by MITANI CORPORATION), and the ratio of a portion where voids were formed was calculated. The porosity was measured in a region where the external quantum efficiency difference was measured. The porosity mentioned here, which is a ratio of voids (portions filled with black in Figs. 5 to 7) in a solid in which the quantum dots and perovskite are complexed (portions surrounded by broken lines in Figs. 5 to 7), is an average value in two or more solids in the field of view.

### <Example 1>

The following steps (1) to (7) were carried out sequentially to prepare a cell.

### (1) Etching and Cleaning of FTO Substrate

A part of a glass substrate with 25 mm square fluorine doped tin oxide (FTO) (manufactured by Asahi Glass Fabritec Corporation, 25 × 25 × 1.8 mm, hereinafter referred to as FTO substrate) was etched with Zn powder and a 2 mol/L hydrochloric acid aqueous solution. Ultrasonic cleaning was carried out for 10 minutes sequentially with 1 mass% neutral detergent, acetone, 2-propanol (IPA), and ion exchanged water.

### (2) Ozone Cleaning

Ozone cleaning of the FTO substrate was performed immediately before the compact TiO₂ layer forming step. With the FTO side facing up, the substrate was placed in an ozone generator (ozone cleaner PC-450 UV, manufactured by Meiwafosis Co., Ltd.) and irradiated with UV for 30 minutes.

### (3) Formation of Compact TiO₂ Layer (Blocking Layer)

Bis(2,4-pentanedionato)bis(2-propanolato) titanium (IV) (4.04 g, 75% IPA solution, manufactured by Tokyo Chemical Industry Co., Ltd.) was dissolved in 123.24 g of ethanol (dehydrated, manufactured by Wako Pure Chemical Industries) to prepare a spray solution. The spray solution was sprayed at a pressure of 0.3 MPa to an FTO substrate on a hot plate (450°C) from a height of about 30 cm. Spraying was repeated twice on the substrates of 20 cm × 8 rows to a spraying amount of about 7 g, and then the sprayed substrate was dried at 450°C for 3 minutes. This operation was repeated twice more to spray a total of about 21 g of the spray solution. Thereafter, the FTO substrate was immersed in an aqueous solution (50 mM) of titanium chloride (manufactured by Wako Pure Chemical Industries, Ltd.) and heated at 70°C for 30 minutes. After washing with water and drying, the FTO substrate was calcined at 500°C for 20 minutes (temperature rising: 15 minutes) to form a compact TiO₂ (cTiO₂) layer.

### (4) Formation of Mesoporous TiO₂ Layer (Porous Layer)

Ethanol (1.41 g, dehydrated, manufactured by Wako Pure Chemical Industries, Ltd.) was added to 0.404 g of an anatase form TiO₂ paste (PST-18NR, manufactured by JGC Catalysts and Chemicals Ltd.) and the mixture was subjected to ultrasonic dispersion for 1 hour to obtain a TiO₂ coating liquid. In a dry room, the TiO₂ coating liquid was spin-coated (5000 rpm × 30 sec) on the cTiO₂ layer using a spin coater (MS-100, manufactured by Mikasa Co., Ltd.). After drying for 30 minutes on a hot plate at 125°C, the cTiO₂ layer was calcined at 500°C for 30 minutes (time for temperature rising: 60 minutes) to form a mesoporous TiO₂ (mTiO₂) layer.

### (5) Formation of Light Absorption Layer

The light absorption layer and the hole transport layer were formed in a glove box at 25°C. Lead bromide (PbBr₂, a precursor for perovskite, 0.228 g, manufactured by Tokyo Chemical Industry Co., Ltd.), 0.070 g of methylamine hydrobromide (CH₃NH₃Br, manufactured by Tokyo Chemical Industry Co., Ltd.), and 2 mL of DMF (dehydrated, manufactured by Wako Pure Chemical Industries, Ltd.) were mixed and stirred at room temperature to prepare a DMF solution (colorless transparent) of 0.31 mol/L perovskite (CH₃NH₃PbBr₃) raw material. Further, 0.20 g of the PbS quantum dot solid in which iodine was coordinated was added to this DMF solution, dispersed with stirring for 15 minutes, and then filtered with a PTFE filter having a pore size of 0.45 µm, thereby to obtain a mixed dispersion (coating liquid) of the PbS quantum dot and the perovskite raw material.

On the mTiO₂ layer, the coating liquid was spin-coated (500 rpm × 5 sec, slope 5 sec, 1000 rpm × 40 sec, slope 5 sec, 3000 rpm × 50 sec) using a spin coater (MS-100, manufactured by Mikasa Corporation). After 25 seconds from the start of spinning, 1 mL of toluene (dehydrated, manufactured by Wako Pure Chemical Industries, Ltd.) as a poor solvent was dropwise added at once to the center portion of the spin. Immediately after spin coating, the spin-coated product was dried on a 100°C hot plate for 10 minutes to form a light absorption layer. The light absorption layer contains a perovskite compound CH₃NH₃PbBr₃, a PbS quantum dot, and a ligand. Formation of the perovskite compound was confirmed by X-ray diffraction pattern, absorption spectrum, and electron microscope observation, and the presence of the quantum dot was also confirmed from fluorescence spectrum and electron microscope observation.

### (6) Formation of Hole Transport Layer

Bis(trifluoromethanesulfonyl)imide lithium (LiTFSI, 9.1 mg, manufactured by Wako Pure Chemical Industries, Ltd.), 8.7 mg of [tris(2-(1H-pyrazol-1-yl)-4-tert-butylpyridine) cobalt(III) tris(bis(trifluoromethylsulfonyl)imide)] (Co(4-tButylpyridyl-2-1H-pyrazole) 3.3 TFSI, manufactured by Wako Pure Chemical Industries, Ltd.), 72.3 mg of 2,2',7,7'-tetrakis[N,N-di-p-methoxyphenylamino]-9,9'-spirobifluorene (Spiro-OMeTAD, manufactured by Wako Pure Chemical Industries, Ltd.), 1 mL of chlorobenzene (manufactured by Nacalai Tesque), and 28.8 µL of tributylphosphine (TBP, manufactured by Sigma-Aldrich) were mixed and stirred at room temperature to prepare a hole transport material (HTM) solution (black-purple transparent). Immediately before use, the HTM solution was filtered through a PTFE filter with a pore size of 0.45 µm. The HTM solution was spin-coated (4000 rpm × 30 sec) on the light absorption layer using a spin coater (MS-100, manufactured by Mikasa Co., Ltd.). Immediately after spin coating, the spin-coated product was dried on a 70°C hot plate for 30 minutes. After drying, the contact part with FTO and the entire back surface of the substrate were wiped off with a cotton swab impregnated with γ-butyrolactone (manufactured by Wako Pure Chemical Industries, Ltd.), further drying was performed on a hot plate at 70°C for several minutes, thereby forming a hole transport layer.

### (7) Deposition of Gold Electrode

Gold was deposited to a thickness of 100 nm on the hole transport layer (vacuum deposition rate: 8 to 9 Å/sec) under vacuum (4 to 5 × 10⁻³ Pa) using a vacuum vapor deposition apparatus (VTR-060M/ERH, manufactured by ULVAC KIKO Inc.) to form a gold electrode.

### <Example 2>

In (5) Formation of Light Absorption Layer of Example 1, a light absorption layer was formed in the same manner as in Example 1 to prepare a cell, except that toluene as the poor solvent was not added dropwise.

### <Comparative Example 1>

In (5) Formation of Light Absorption Layer of Example 1, a light absorption layer was formed in the same manner as in Example 1 to prepare a cell, except that toluene as the poor solvent was added dropwise 20 seconds after the start of spinning.

**[Table 1]**

| | | Example 1 | Example 2 | Comparative Example 1 |
|---|---|---|---|---|
| Perovskite (P) | Compound | CH₃NH₃PbBr₃ | CH₃NH₃PbBr₃ | CH₃NH₃PbBr₃ |
| | Band gap energy (eV) | 2.3 | 2.3 | 2.3 |
| Quantum dot (QD) | Compound | PbS | PbS | PbS |
| | Particle diameter (nm) | 3.4 | 3.4 | 3.2 |
| | Band gap energy (eV) | 1.0 | 1.0 | 1.0 |
| | Blending amount in terms of PbS (% by mass) | 23 | 23 | 24 |
| Light absorption layer | Absorbance ratio (QD/P) | 0 | 0 | 0 |
| | Absorbance of perovskite | 0.78 | 0.79 | 0.75 |
| | Thickness (nm) | < 300 | < 200 | < 100 |
| | Crystallite diameter of perovskite (nm) | 41 | 42 | 35 |
| | Porosity (average value) (%) | 2.4 | 5.2 | 12.8 |
| Cell characteristics | External quantum efficiency difference at 820 nm (%) | 6.3×10⁻² | 5.9×10⁻² | 3.5×10⁻⁴ |
| | External quantum efficiency difference at 1240 nm (%) | 2.8×10⁻² | 3.8×10⁻² | 4.5×10⁻⁵ |
| Band structure | Intermediate-band | Present | Present | Present |
| | Intermediate-band-valence band (eV) | 1.5 | 1.5 | 1.5 |
| | Conduction band-intermediate-band (eV) | 0.8 | 0.8 | 0.8 |

### INDUSTRIAL APPLICABILITY

The light absorption layer and the photoelectric conversion element of the present invention can be suitably used as a constituent member of an intermediate-band solar cell.

### DESCRIPTION OF REFERENCE SIGNS

- 1: Photoelectric conversion element
- 2: Transparent substrate
- 3: Transparent conductive layer
- 4: Blocking layer
- 5: Porous layer
- 6: Light absorption layer
- 7: Hole transport layer
- 8: Electrode (positive electrode)
- 9: Electrode (negative electrode)
- 10: Light

## Claims

1. A light absorption layer, wherein quantum dots are dispersed in a matrix of a bulk semiconductor having a band gap energy of 2.0 eV or more and 3.0 eV or less, and the light absorption layer has an intermediate-band and has a porosity of 10% or less.

2. The light absorption layer according to claim 1, wherein an energy difference between the intermediate-band and a conduction band of the bulk semiconductor is 0.5 eV or more and 2.0 eV or less.

3. The light absorption layer according to claim 1 or 2, wherein an energy difference between a valence band of the bulk semiconductor and the intermediate-band is 1.1 eV or more and 2.0 eV or less.

4. The light absorption layer according to any one of claims 1 to 3, wherein a band gap energy of the quantum dots is 0.2 eV or more and less than the band gap energy of the bulk semiconductor.

5. The light absorption layer according to any one of claims 1 to 4, wherein a content of the quantum dots is 7.5% by mass or more.

6. The light absorption layer according to any one of claims 1 to 5, wherein the bulk semiconductor is an organic-inorganic composite compound.

7. The light absorption layer according to any one of claims 1 to 6, wherein the bulk semiconductor is a perovskite compound.

8. The light absorption layer according to claim 7, wherein the perovskite compound is one or more kinds selected from a compound represented by the following general formula (1) and a compound represented by the following general formula (2):
RMX₃ (1)
wherein R is a monovalent cation, M is a divalent metal cation, and X is a halogen anion, and
R¹R²R³ₙ₋₁MₙX₃ₙ₊₁ (2)
wherein R¹, R² and R³ are each independently a monovalent cation, M is a divalent metal cation, X is a halogen anion, and n is an integer of 1 to 10.

9. The light absorption layer according to claim 8, wherein X is a fluorine anion, a chlorine anion, a bromine anion or an iodine anion.

10. The light absorption layer according to claim 8 or 9, wherein R is one or more kinds selected from an alkylammonium ion and a formamidinium ion.

11. The light absorption layer according to any one of claims 8 to 10, wherein R¹, R² and R³ are one or more kinds selected from an alkylammonium ion and a formamidinium ion.

12. The light absorption layer according to any one of claims 8 to 11, wherein M is Pb²⁺, Sn²⁺ or Ge²⁺.

13. A dispersion for manufacturing the light absorption layer according to any one of claims 1 to 12, comprising the bulk semiconductor having a band gap energy of 2.0 eV or more and 3.0 eV or less and/or a precursor thereof and the quantum dots.

14. The dispersion according to claim 13, comprising a solvent.

15. The dispersion according to claim 13 or 14, wherein a solid content concentration of the quantum dots in the dispersion is 10 mg/mL or more and 100 mg/mL or less.

16. A light absorption layer obtained from the dispersion according to any one of claims 13 to 15.

17. A method for manufacturing a light absorption layer having an intermediate-band and having a porosity of 10% or less, wherein quantum dots are dispersed in a matrix of a bulk semiconductor, which method comprises the following step 1, step 2, and step 3:
(step 1) a step of ligand-exchanging the organic ligand of an organic ligand-containing quantum dot to a halogen element-containing substance to obtain a quantum dot solid containing the halogen element-containing substance as a ligand,
(step 2) a step of obtaining a dispersion by mixing the quantum dot solid obtained in step 1 with a solution or mixed solution containing one or more substances selected from a bulk semiconductor and a precursor thereof,
(step 3) a step of obtaining a light absorption layer from the dispersion obtained in step 2.

18. A photoelectric conversion element having the light absorption layer according to any one of claims 1 to 12 and 16.

19. An intermediate-band solar cell having the photoelectric conversion element according to claim 18.
